(19) Europäisches Patentamt
European Patent Office
Office européen des brevets

(11) EP 3 124 552 B1

(12) **EUROPEAN PATENT SPECIFICATION**

(45) Date of publication and mention of the grant of the patent:
**11.04.2018 Bulletin 2018/15**

(21) Application number: **15306227.8**

(22) Date of filing: **28.07.2015**

(51) Int Cl.:
*C09B 47/06* (2006.01) *C09B 47/067* (2006.01)
*H01G 9/20* (2006.01) *C09B 47/04* (2006.01)
*C09B 47/00* (2006.01) *H01L 51/00* (2006.01)

(54) **TRANS-DISUBSTITUTED BENZODIAZAPORPHYRINS AS SENSITIZERS FOR SOLAR CELLS**

TRANSDISUBSTITUIERTE BENZODIAZAPORPHYRINE ALS SENSIBILISATOREN FÜR SOLARZELLEN

BENZODIAZAPORPHYRINS TRANS-DISUBSTITUÉS COMME SENSIBILISATEURS POUR CELLULES SOLAIRES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**01.02.2017 Bulletin 2017/05**

(73) Proprietors:
- **Université de Nantes
44035 Nantes (FR)**
- **CENTRE NATIONAL DE LA RECHERCHE SCIENTIFIQUE -CNRS-
75016 Paris (FR)**
- **Department of Chemistry of the Lomonosov Moscow State University
Moscow 119992 (RU)**

(72) Inventors:
- **ODOBEL, Fabrice
44300 NANTES (FR)**
- **CHEPRAKOV, Andrey V.
123154 MOSCOW (RU)**
- **ANDRIANOV, Dmitry S.
125319 MOSCOW (RU)**

(74) Representative: **Cabinet Plasseraud
66, rue de la Chaussée d'Antin
75440 Paris Cedex 09 (FR)**

(56) References cited:
- **Rebekah Theisen ET AL: "Theoretical Characterization of Zinc Phthalocyanine and Porphyrin Analogs for Organic Solar Cell Absorption", , 1 January 2014 (2014-01-01), XP055232149, ISBN: 978-1-321-32800-4 Retrieved from the Internet: URL:http://repository.asu.edu/attachments/140796/content/Theisen_asu_0010E_14304.pdf [retrieved on 2015-11-30]**
- **ANDREW N. CAMMIDGE ET AL: "Phthalocyanine Analogues: Unexpectedly Facile Access to Non-Peripherally Substituted Octaalkyl Tetrabenzotriazaporphyrins, Tetrabenzodiazaporphyrins, Tetrabenzomonoazaporphyrins and Tetrabenzoporphyrins", CHEMISTRY - A EUROPEAN JOURNAL., vol. 17, no. 11, 7 March 2011 (2011-03-07) , pages 3136-3146, XP055232141, WEINHEIM, DE ISSN: 0947-6539, DOI: 10.1002/chem.201002176**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 124 552 B1

## Description

This invention relates to dye-sensitive light absorbing species and, more particularly, to *trans*-disubstituted benzodiazaporphyrins useful in dye-sensitive light absorbing applications especially active in the long wavelength spectrum range.

## STATE OF THE ART

Dye-sensitized solar cells (DSSCs) and organic solar cells (OSCs) have the potential to provide photovoltaic energy at competitive price with a clean and sustainable technology. In the area of DSSCs, ruthenium polypyridine complexes have been the most efficient sensitizers for several decades (photoconversion efficiencies in the range of 10-11%), while in the OSC the development of small photoactive molecules is gaining an increase in attention.

Early 2000, in the field of DSSCs, new organic dyes were synthesized to get rid of the costly and noxious ruthenium element. It was discovered that push-pull systems, comprising a $\pi$-conjugated spacer functionalized by an electron donating group and an electron withdrawing group, are particularly efficient sensitizers in DSSCs.

More recently, zinc porphyrin sensitizers have attracted a strong interest in DSSCs because cells with such sensitizers attained the record efficiency of 13%.The most performing porphyrins are YD2 and SM315, as disclosed in Yella, A. et al., Science, 2011, 334, 629-634 and Mathew, S. et al., Nat. Chem., 2014, 6, 242-247. YD2 and SM315 are push-pull systems, containing namely a diaryl amino unit as electron donating group and a benzoic acid or a benzothiadiazole unit as electron withdrawing group, as shown below.

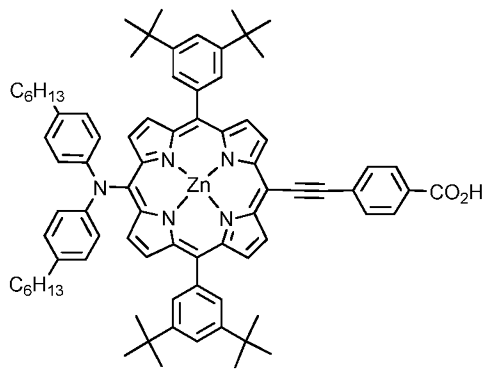

**YD2**

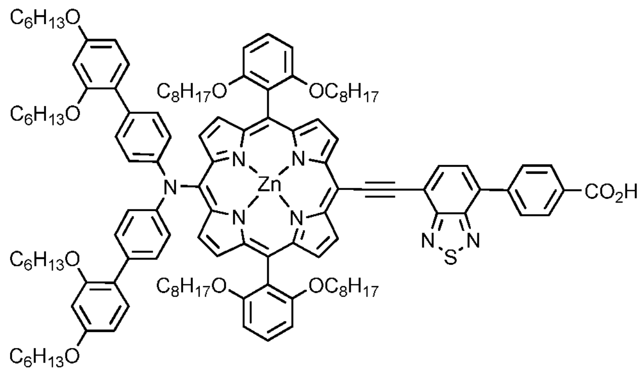

**SM315**

However, a strong drawback of porphyrin dyes is their weak absorbance both at around 450 nm, and above 750 nm where the incoming solar flux is still significant. Zinc porphyrin absorption spectrum features a strong absorption band around 420 nm (Soret band) and two weaker absorption bands between 500-600 nm (Q-bands) with an almost transparent region around 450-500 nm. This weak light harvesting efficiency in this region certainly limits the overall photovoltaic performances of this class of dyes.

A theoretical characterization of zinc phtalocyanine and porphyrin analogues for organic solar cell absorption is described by R. Theisen, Disseration, Arizona State University, 2014. Phthalocyanines are $\pi$-conjugated macrocycles related to porphyrins which have also been thoroughly investigated as sensitizers in DSSCs and OSCs. Today, the highest power conversion efficiency (PCE) obtained with a phthalocyanine in DSSCs is 6.4% and can be obtained with PcS20 represented below, wherein $R_1$ and $R_2$ are butoxy and $R_3$ is H, as disclosed in Ikeuchi, T. et al., Chem. Commun., 2014, 50, 1941-1943.

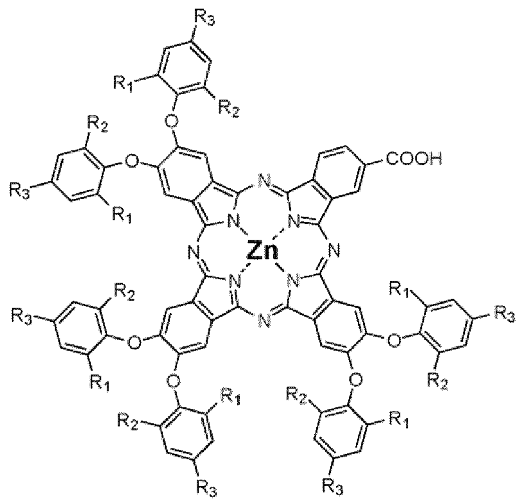

**PcS20**

A valuable property of phthalocyanines is their strong absorption band located around 670 nm, which enables to obtain a high photoactivity (IPCE around 80%) in a low energy region of the visible spectrum. On the other hand, the higher energy region (between 420-600 nm) is poorly exploited by phthalocyanine dyes owing to the low absorption coefficient in this region. Moreover, the preparation of *trans* disubtituted phtalocyanines is an extremely tedious and challenging synthetic task, which limits the possibility to develop push-pull dyes for solar cell applications.

Benzodiazaporphyrins can be considered as hybrid dyes between porphyrins and phthalocyanines since two of the bridging *meso* positions are occupied by nitrogen like phthalocyanines, while the two other *meso* positions are regular methene moieties which can carry substituents. The two interesting and valuable features of benzodiazaporphyrins is first, the presence of an intense and long wavelength absorption band like phthalocyanines, and the possibility to envision the preparation of push-pull or quadrupolar systems by *trans* functionalization of the two adjacent carbon *meso* positions.

The straightforward and efficient synthesis of *trans* disubstituted benzodiazaporphyrins was recently disclosed in Andrianov, D. S. et al., Chem. Commun. 2014, 50, 7953-7955. However, the structures of the benzodiazaporphyrins disclosed in said reference are not suited for solar cell applications.

The Applicant has now found *trans* disubstituted benzodiazaporphyrins that are highly efficient dye sensitizers for solar cells, particularly for DSSCs or OSCs because they have a strong absorption band in the NIR region and can be used to produce solar cells with interesting power conversion efficiencies (PCEs).

## SUMMARY OF THE INVENTION

A first object of the present invention is a compound of general formula (I):

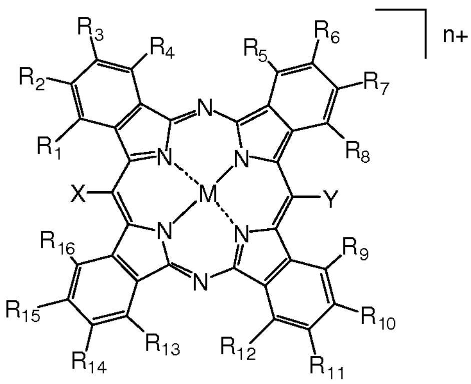

(I)

wherein $R_1$-$R_{16}$, X, Y and n are as defined herein.

Another object of the present invention is a dye-sensitized solar cell comprising an anode, a counter-electrode,

a nanocrystalline semiconductor, a sensitizer and an electrolyte, wherein the sensitizer is a compound of general formula (II):

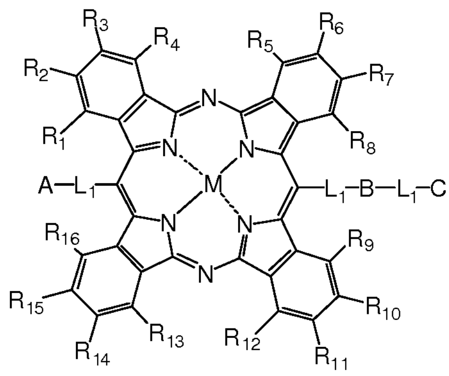

(II)

wherein $R_1$-$R_{16}$, A, B,C, $L_1$ and M are as defined herein.

Yet another object of the present invention is the use of a compound of general formula (II) as a sensitizer for a dye-sensitized solar cell.

Another object of the present invention is an organic solar cell comprising an anode, a cathode and a sensitizer, wherein said sensitizer is a compound of general formula (V):

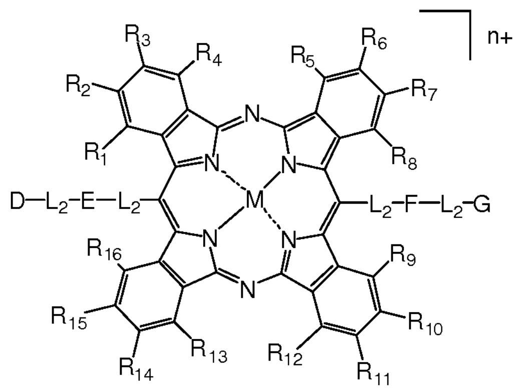

(V)

wherein $R_1$-$R_{16}$, D, E,F, G, $L_2$, M and n are as defined herein.

Yet another object of the present invention is the use of a compound of general formula (V) as a sensitizer for an organic solar cell.

**DESCRIPTION OF FIGURES**

Figure 1 shows the synthetic route for the preparation of **CROSSDAP.**

Figure 2 shows the synthetic route for the preparation of **TPA-CROSSDAP.**

Figure 3 shows the electronic absorption (straight line) and emission spectra (dashed line) of **CROSSDAP** recorded in dimethylformamide.

Figure 4 shows the electronic absorption (straight line) and emission spectra (dashed line) of a precursor of **TPA-CROSSDAP** recorded in dichloromethane.

Figure 5 shows the current/voltage characteristics of a DSSC sensitized with **CROSSDAP** recorded in the dark (dashed line) and under AM 1.5 illumination (straight line).

Figure 6 shows the photoaction spectra (Incident photon-to-current efficiency (IPCE) as a function of the incident wavelength) of a DSSC sensitized with **CROSSDAP.**

**DEFINITIONS**

Unless mentioned otherwise, the groups and radicals listed for X, Y, $R_1$-$R_{16}$, A, B, C, D, E, F, G, $L_1$ and $L_2$ may be substituted or unsubstituted. By "substituted" it is meant that one of the hydrogen atoms of said group or radical is replaced with a substituent other than H. Examples of suitable substituents are halogen atoms, such as Cl, Br, I and F; and groups selected from alkyl, cycloalkyl, alkoxy, aryl, heteroaryl, cyano, amino, dialkylamino, diarylamino, triarylamino, dialkylarylamino, thioether, a carboxylic group, a sulfonic group.

The term "alkyl" means any monovalent radical of a linear or branched hydrocarbon chain comprising 1 to 18 carbon atoms. The expression "$C_1$-$C_6$ alkyl" represents an alkyl having 1 to 6 carbon atoms. Examples of alkyl groups include methyl, ethyl, *n*-propyl, *i*-propyl, *n*-butyl, *i*-butyl, *s*-butyl or *t*-butyl, *n*-pentyl, *n*-hexyl, *n*-heptyl, *n*-octyl, 2-ethylhexyl, *n*-nonyl, 3,5,5-trimethylhexyl, *n*-decyl, n-undecyl, *n*-dodecyl or *n*-octadecyl. Preferred alkyls are methyl, ethyl, isopropyl and *t*-butyl.

The term "alkoxy" means an -O-alkyl group wherein the term alkyl is as defined above. The expression "$C_1$-$C_6$ alkoxy" represents an alkoxy having 1 to 6 carbon atoms. Examples of alkoxy groups include methoxy, ethoxy, *n*-propoxy, *i*-propoxy, *n*-butoxy, *i*-butoxy, *s*-butoxy or *t*-butoxy, *n*-pentoxy, *n*-hexoxy. Preferred alkoxys are methoxy, ethoxy, isopropoxy and *t*-butoxy.

The term "aryl" means any monovalent radical of an aromatic hydrocarbon ring comprising 6 to 12 carbon atoms. The expression "$C_6$-aryl" represents an aryl having 6 carbon atoms. Examples of aryls include phenyl, naphthyl and biphenyl. Preferred aryls are phenyl and naphthyl.

The term "phenoxy" means an -O-phenyl group.

The term "thioether" means an -S-alkyl group or -S-aryl group wherein the terms alkyl and aryl are as defined above. The expression "$C_1$-$C_6$ thioether" represents a thioether having 1 to 6 carbon atoms. Examples of thioether groups include thiomethyl and thiophenyl (-S-Ph).

The term "heteroaryl" means any monovalent radical of an aromatic 5 to 6 membered monocyclic ring or 9 to 20 membered bicyclic ring which can comprise 1, 2 or 3 heteroatoms selected from nitrogen, oxygen and/or sulphur. The expression "5- to 10-membered heteroaryl" means a heteroaryl with 5 to 10 ring atoms. Examples of heteroaryls include furyl, pyridinyl, pyridazinyl, pyrimidinyl, pyrazinyl, thienyl, isoxazolyl, oxazolyl, oxadiazolyl, imidazolyl, pyrrolyl, pyrazolyl, triazolyl, tetrazolyl, thiazolyl, isothiazolyl, thiadiazolyl, benzoimidazolyl, indolyl, indanyl, indazolyl, benzothiazolyl, benzoisothiazolyl, benzoxazolyl, benzoisoxazolyl, benzothiadiazolyl, benzotriazolyl, quinolinyl, isoquinolinyl, a monovalent pyridinium radical, a monovalent diketopyrrolopyrrole radical and a monovalent isoindigo radical. Preferred heteroaryls are thienyl, benzothiadiazolyl, benzotriazolyl, pyridinyl, triazolyl, a monovalent pyridinium radical, a monovalent diketopyrrolopyrrole radical and a monovalent isoindigo radical.

When the suffixes "ene" or "diyl" are used in conjunction with an alkyl, aryl or heteroaryl group, this means that the alkyl, aryl or heteroaryl group defined above is a divalent radical, i.e. it has two points of attachment to other groups.

The term "cycloalkyl" means a non-aromatic cyclic hydrocarbon chain comprising 5 to 7 carbon atoms.

The term "alkendiyl" means any divalent radical of a hydrocarbon chain comprising 2 carbon atoms and 1 carbon-carbon double bond or 4 carbon atoms and two conjugated carbon-carbon double bonds or 6 carbon atoms and three conjugated carbon-carbon double bonds.

The term "alkyndiyl" means any divalent radical of a hydrocarbon chain comprising 2 carbon atoms and 1 triple carbon-carbon bond or 4 carbon atoms and two conjugated triple carbon-carbon bonds or 6 carbon atoms and three conjugated triple carbon-carbon bonds.

The term "amino" means a $-NH_2$ group.

The term "dialkyl amino" means an amino group wherein each hydrogen has been replaced with an alkyl group.

The term "diaryl amino" means an amino group wherein each hydrogen has been replaced with an aryl group.

The term "triaryl amino" means an aryl group wherein one H has been substituted by a diaryl amino group.

The term "dialkylaryl amino" means an aryl group wherein one H has been substituted by a dialkyl amino group.

The term "oligothienyl" means a monovalent radical of an oligomer of thiophene monomers linked together in positions 2 and 5 by a single bond.

The term "carboxylic group" means a group of general formula $-COOR_c$ wherein $R_c$ is H, a metallic cation or an alkyl group as defined above.

The term "sulfonic group" means a group of general formula $-S(=O)_2OR_d$ wherein $R_d$ is H, a metallic cation or an alkyl group as defined above.

## DETAILED DESCRIPTION OF THE INVENTION

### Sensitizer Compounds

The compounds of the present invention have a central benzodiazaporphyrin core onto which are branched two groups X and Y in *trans* position.

As such, compounds of the present invention are represented by general formula (I):

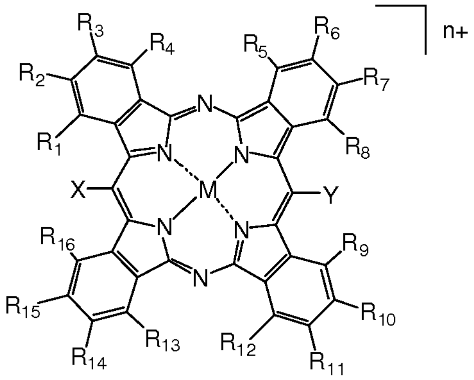

(I)

wherein

$R_1$-$R_{16}$ are each independently selected from H, alkyl and aryl; or two adjacent $R_1$-$R_{16}$ groups optionally form, together with the carbon atoms to which they are attached, a ring selected from cycloalkyl and aryl, and the remaining $R_1$-$R_{16}$ groups are each independently selected from H, alkyl and aryl;

X and Y, similar or different, each comprise at least one group selected from H, alkyl, aryl, arylene, heteroaryl, heteroarylene, alkendiyl, alkyndiyl, dialkyl amino, diaryl amino, triaryl amino and dialkylaryl amino;

M represents 2 hydrogen atoms; or M is selected from Zn, Mg, Al, Si, Cu, Ru, Au, Sn, Pd, Pt, Ir and Ni; or M is selected from $Sn(IV)(L)_2$, $P(V)(L)_2$, Au(III), Ru(II)LL', Ir(III) wherein L and L' represent axial ligands selected from halogeno, hydroxo, alkoxide, carboxylato, CO, and pyridine;

n is 0 or 1 ;

with the proviso that X and Y are not both H, or both alkyl or both aryl.

In a first embodiment, compounds of the present invention correspond to general formula (II):

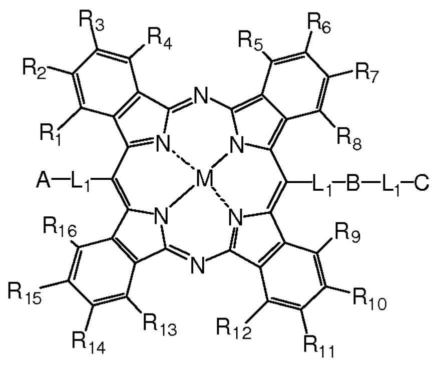

(II)

wherein

$R_1$-$R_{16}$ are each independently selected from H, alkyl and aryl; or two adjacent $R_1$-$R_{16}$ groups optionally form, together with the carbon atoms to which they are attached, a ring selected from cycloalkyl and aryl, and the remaining $R_1$-$R_{16}$ groups are each independently selected from H, alkyl and aryl;

A is selected from H, alkyl, aryl, dialkyl amino, diaryl amino, triaryl amino, dialkylaryl amino, thienyl, oligothienyl,

and combinations thereof;

B is selected from arylene, heteroarylene, alkendiyl, alkyndiyl and combinations thereof;

C is selected from $-COOR_a$, $-COO^-$, $-PO_3H_2$, $-PO(OH)R_b$, $-CH=C(COOH)_2$, -CH=C(CN)(COOH), $-Si(OR_b)_3$, and $-C(O)-CH_2-C(O)-CH_3$ wherein $R_a$ is H, alkyl, amino, dialkylamino, diaryl amino or $-C(O)-R_b$ and wherein $R_b$ is alkyl;

$L_1$ are each independently selected from a single bond, $-(C{\equiv}C)_m-$, and $-(CH=CH)_o-$, wherein m and o are integers independently equal to 1, 2 or 3;

M represents 2 hydrogen atoms; or M is selected from Zn, Mg, Al, Si, Cu, Ru, Au, Sn, Pd, Pt, Ir and Ni.

In particular, $R_1$, $R_4$, $R_5$, $R_8$, $R_9$, $R_{12}$, $R_{13}$ and $R_{16}$ may be H; and $R_2$ with $R_3$; $R_6$ with $R_7$; $R_{10}$ with $R_{11}$; and $R_{14}$ with $R_{15}$; may, together with the carbon atoms to which they are attached, form a ring selected from cycloalkyl and aryl, more particularly a ring selected from $C_6$-cycloalkyl and $C_6$-aryl; even more particularly a ring selected from phenyl, cyclohexyl and cyclohexyl substituted with 1 to 4 methyl groups.

In particular, the $R_1$-$R_{16}$ groups of the compounds of general formula (II) may each be independently selected from H, $C_1$-$C_6$-alkyl and $C_6$-aryl. More particularly, $R_1$-$R_{16}$ may all be H; or $R_1$-$R_{16}$ may each be independently selected from H and $C_1$-$C_6$-alkyl; or $R_1$-$R_{16}$ may each be independently selected from H and $C_6$-aryl. Even more particularly, $R_1$-$R_{16}$ may each be independently selected from H, methyl, ethyl, isopropyl, tert-butyl and hexyl; or $R_1$-$R_{16}$ may each be independently selected from H and phenyl optionally substituted by one or two substituents independently selected from alkyl, alkoxy, phenoxy, dialkylamino, diphenylamino, thioether, carboxylic group and sulfonic group.

In particular, the A group of the compounds of general formula (II) may be selected from H, $C_1$-$C_6$-alkyl, $C_6$-aryl, di-$C_1$-$C_6$-alkyl amino, di-$C_6$-aryl amino, tri-$C_6$-aryl amino, di-$C_1$-$C_6$-alkyl-$C_6$-aryl amino, thienyl, oligothienyl, and combinations thereof. More particularly, A may be selected from phenyl, diphenylamino, triphenylamino wherein said groups may optionally be substituted by one or two substituents selected from alkyl, alkoxy and thioether. Even more particularly A may be di(*t*-butyl)phenyl, diphenylamino, bis(4-methoxyphenyl)amino, bis(4-hexylphenyl)amino, diphenylamino wherein each phenyl is substituted with a dihexyloxyphenyl, phenyl substituted with diphenylamino, phenyl substituted with bis(4-methoxyphenyl)amino, and phenyl substituted with diphenylamino wherein each phenyl group of the diphenylamino substituent are further substituted with a dihexyloxyphenyl.

In particular, the B group of the compounds of general formula (II) may be selected from $C_6$-arylene, 5-to 10-membered heteroarylene, -CH=CH-, -C=C-, and combinations thereof. More particularly, B may be selected from phenylene, thiendiyl, benzothiadiazoldiyl, benzotriazoldiyl, pyridindiyl, triazoldiyl, -CH=CH-, -C=C-, and combinations thereof. Even more particularly, B may be a 1,4-phenylene optionally substituted by one or two substituents selected from fluoro and cyano.

In particular, the C group of the compounds of general formula (II) may be selected from -COOH, $-PO_3H_2$, -CH=C(CN)(COOH), $-Si(OMe)_3$, $-Si(OEt)_3$ and $-C(O)-CH_2-C(O)-CH_3$. More particularly, C may be selected from -COOH and CH=C(CN)(COOH). Even more particularly, C may be -COOH.

In particular, the $L_1$ groups of the compounds of general formula (II) may each be independently selected from a single bond, -C=C- and -CH=CH-. More particularly each $L_1$ may independently be selected from a single bond and -C=C-. Even more particularly, each $L_1$ may be a single bond.

In particular, the M group of the compounds of general formula (II) may represent 2 hydrogen atoms or M may be selected from Zn, Mg, Al, Si, Cu, Ru and Ni. More particularly M may be selected from Zn, Mg and Cu. Even more particularly, M may be Zn.

As such, the compounds of the first embodiment of the present invention may correspond to general formula (II) wherein

$R_1$-$R_{16}$ are each independently selected from H, $C_1$-$C_6$-alkyl and $C_6$-aryl;

A is selected from H, $C_1$-$C_6$-alkyl, $C_6$-aryl, di-$C_1$-$C_6$-alkyl amino, di-$C_6$-aryl amino, tri-$C_6$-aryl amino, di-$C_1$-$C_6$-alkyl-$C_6$-aryl amino, thienyl, oligothienyl, and combinations thereof;

B is selected from $C_6$-arylene, 5- to 10-membered heteroarylene, -C=C-, -CH=CH- and combinations thereof; in particular B is selected from phenylene, thiendiyl, benzothiadiazoldiyl, benzotriazoldiyl, pyridindiyl, triazoldiyl, -C=C-, -CH=CH-, and combinations thereof;

C is selected from -COOH, $-PO_3H_2$, -CH=C(CN)(COOH), $-Si(OMe)_3$, $-Si(OEt)_3$ and $-C(O)-CH_2-C(O)-CH_3$; $L_1$ are each independently selected from a single bond, -C=C- and -CH=CH-;

M represents 2 hydrogen atoms; or M is selected from Zn, Mg, Al, Si, Cu, Ru and Ni; in particular Zn, Mg and Cu; preferably Zn.

In a preferred embodiment, the compounds of general formula (II) may correspond to general formula (III) or (IV)

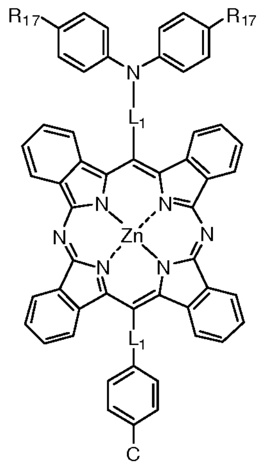

(III)

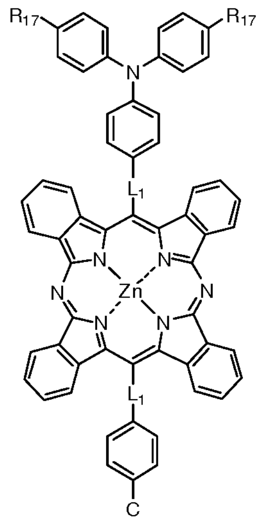

(IV)

wherein

$R_{17}$ is independently selected from H, alkoxy and phenyl substituted by one or two alkoxy groups;
$L_1$ is independently selected from single bond and -C=C-; and
C is independently selected from -COOH and -CH=C(CN)(COOH).

More preferably, the compounds of formula (II), (III) and (IV) are selected from:

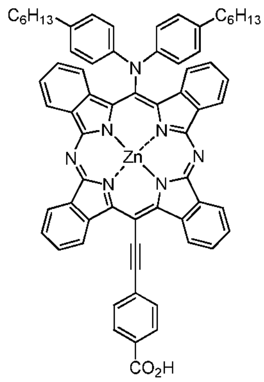

,

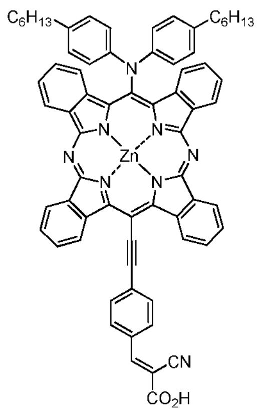

,

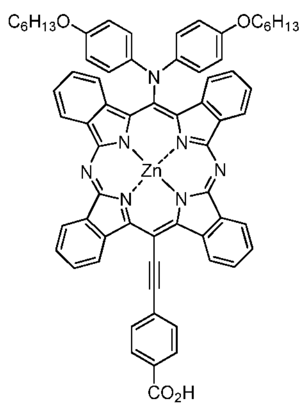

,

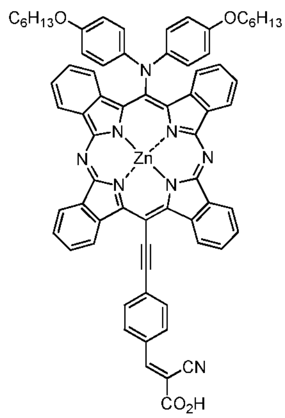

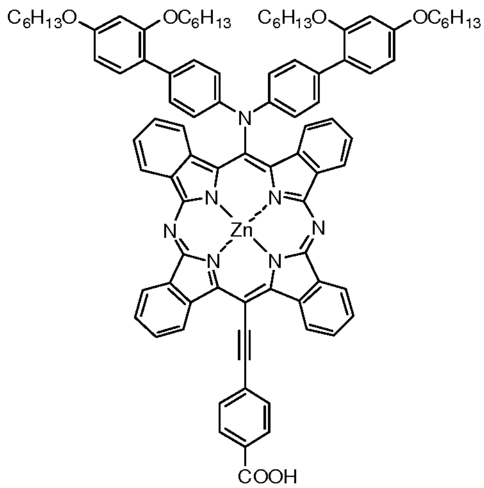
,
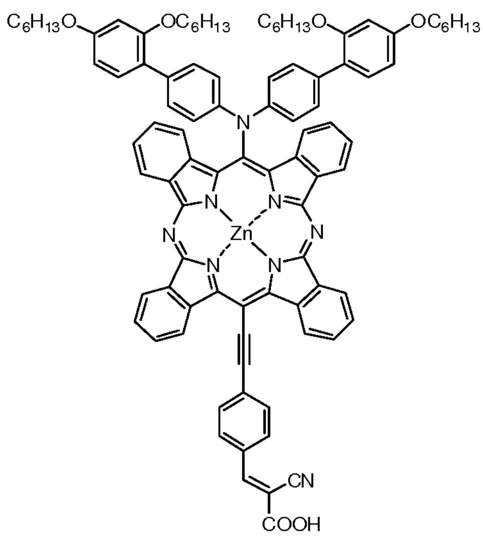
,

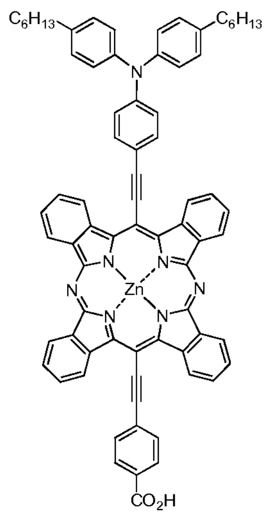
,
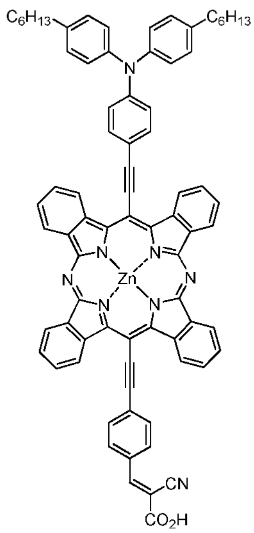
,
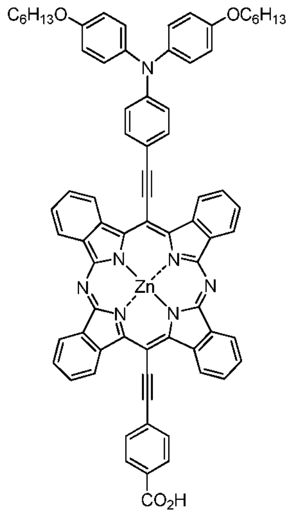
,
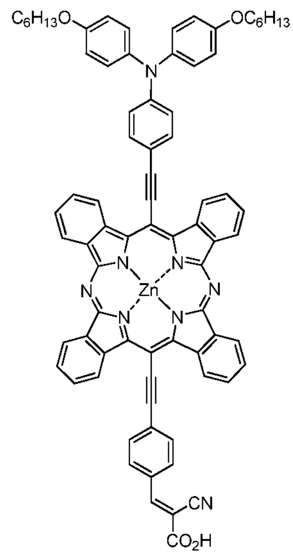
,

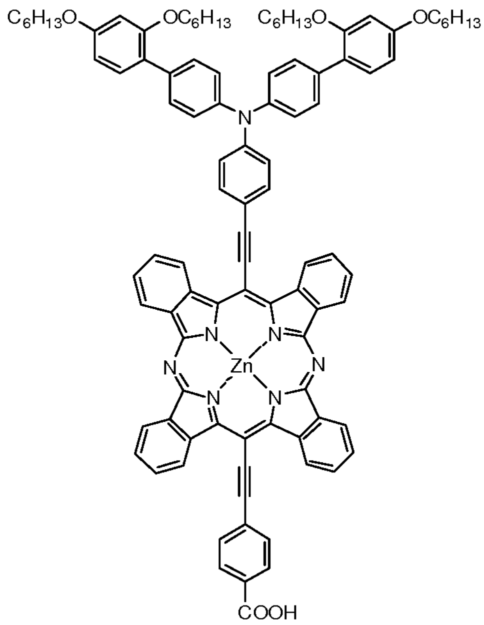

,

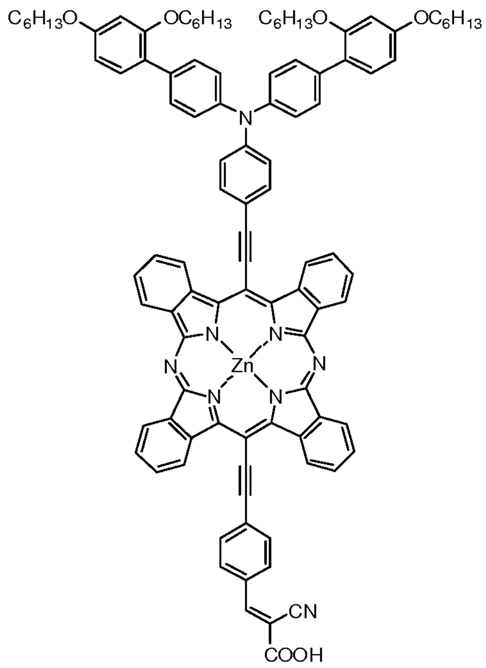

,

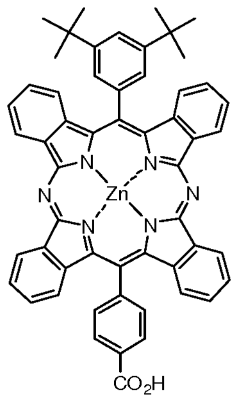

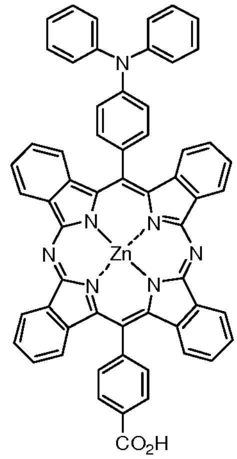

**CROSSDAP** , **TPA-CROSSDAP** .

In a second embodiment, compounds of the present invention correspond to general formula (V):

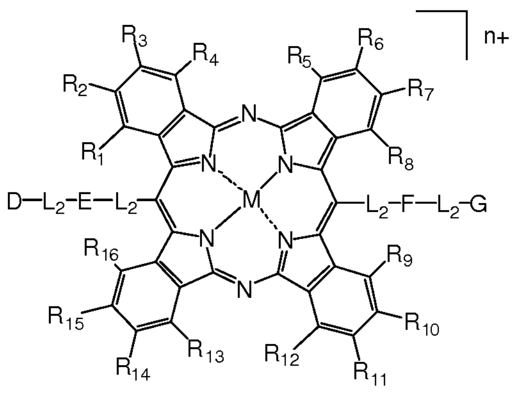

(V)

wherein

$R_1$-$R_{16}$ are each independently selected from H, alkyl and aryl; or two adjacent $R_1$-$R_{16}$ groups optionally form, together with the carbon atoms to which they are attached, a ring selected from cycloalkyl and aryl, and the remaining $R_1$-$R_{16}$ groups are each independently selected from H, alkyl and aryl;
D and G are each independently selected from H, alkyl, aryl, heteroaryl, oligothienyl, dialkyl amino, diaryl amino, triaryl amino, dialkylaryl amino, alkenyl, and combinations thereof;
E and F are each independently selected from arylene, heteroarylene, alkendiyl, alkyndiyl, and combinations thereof;
$L_2$ are each independently selected from a single bond, $-(C{\equiv}C)_p-$ and $-(CR{=}CR)_q-$, wherein R is H or -CN and wherein p and q are integers independently equal to 1, 2 or 3;
M represents 2 hydrogen atoms; or M is selected from Zn, Mg, Al, Si, Cu, Ru, Au, Sn, Pd, Pt, Ir and Ni; or M is selected from $Sn(IV)(L)_2$, $P(V)(L)_2$, Au(III), Ru(II)LL', Ir(III) wherein L and L' represent axial ligands selected from halogeno, hydroxo, alkoxide, carboxylato, CO and pyridine; and
n is 0 or 1.

In a preferred embodiment, the compounds of the second embodiment of the present invention may correspond to general formula (V) wherein the sequence D-$L_2$-E-$L_2$- is identical to the sequence -$L_2$-F-$L_2$-G. Indeed, the synthesis of such compounds is easy and convergent.

In particular, $R_1$, $R_4$, $R_5$, $R_8$, $R_9$, $R_{12}$, $R_{13}$ and $R_{16}$ may be H; and $R_2$ with $R_3$; $R_6$ with $R_7$; $R_{10}$ with $R_{11}$; and $R_{14}$ with $R_{15}$; may, together with the carbon atoms to which they are attached, form a ring selected from cycloalkyl and aryl, more particularly a ring selected from $C_6$-cycloalkyl and $C_6$-aryl; even more particularly a ring selected from phenyl, cyclohexyl and cyclohexyl substituted with 1 to 4 methyl groups.

In particular, the $R_1$-$R_{16}$ groups of the compounds of general formula (V) may each be independently selected from H, $C_1$-$C_6$-alkyl and $C_6$-aryl. More particularly, $R_1$-$R_{16}$ may all be H; or $R_1$-$R_{16}$ may each be independently selected from H and $C_1$-$C_6$-alkyl; or $R_1$-$R_{16}$ may each be independently selected from H and $C_6$-aryl. Even more particularly, $R_1$-$R_{16}$ may each be independently selected from H, methyl, ethyl, isopropyl, tert-butyl and hexyl; or $R_1$-$R_{16}$ may each be independently selected from H and phenyl optionally substituted by one or two substituents selected from alkyl, alkoxy, phenoxy, dialkylamino, diphenylamino, thioether, carboxylic group and sulfonic group.

In particular, the D and G groups of the compounds of general formula (V) may each be independently selected from H, $C_1$-$C_6$-alkyl, $C_6$-aryl, 5- to 20-membered heteroaryl, oligothienyl, di-$C_1$-$C_6$-alkyl amino, di-$C_6$-aryl amino, tri-$C_6$-aryl amino, di-$C_1$-$C_6$-alkyl-$C_6$-aryl amino, alkenyl, and combinations thereof. More particularly, D and G may be independently selected from H, $C_1$-$C_6$-alkyl, $C_6$-aryl, di-$C_1$-$C_6$-alkyl amino, di-$C_6$-aryl amino, tri-$C_6$-aryl amino, di-$C_1$-$C_6$-alkyl-$C_6$-aryl amino, thienyl, oligothienyl, and combinations thereof; or D and G may be independently selected from H, $C_6$-aryl, 5- to 20-membered heteroaryl, alkenyl, and combinations thereof. Even more particularly, D and G may be independently selected from phenyl, diphenyl amino and triphenylamino; wherein said groups may optionally be substituted by one or two substituents selected from alkyl, alkoxy, phenoxy, dialkylamino, diphenylamino, thioether, carboxylic group and sulfonic group; or D and G may be independently selected from phenyl, thienyl optionally fused with an *N*-alkyl pyrrolidine-2,5-dione, benzothiadiazolyl optionally fused with a 2-alkyl triazole, benzotriazolyl, pyridinyl, triazolyl, phthalimidyl, a pyridinium radical, a diketopyrrolopyrrole radical, an isoindigo radical, a *N*-alkyl-2,2'-bithiophene-3,3'-dicarboximide radical, dicyanovinyl, tricyanovinyl, and combinations thereof.

In particular, the E and F groups of the compounds of general formula (V) may be independently selected from $C_6$-arylene, 5- to 10-membered heteroarylene, -C=C-, -CR=CR-, and combinations thereof, wherein R is H or -CN. More particularly, E and F may be independently selected from phenylene, thiendiyl, benzothiadiazoldiyl, benzotriazoldiyl, pyridindiyl, triazoldiyl, -C=C-, -CH=CH-, and combinations thereof. Even more particularly, E and F may be selected from 1,4-phenylene and 2,5-thiendiyl.

In particular, the $L_2$ groups of the compounds of general formula (V) may each be independently selected from a single bond, -C=C- and -CR=CR-, wherein R is H or -CN. More particularly, each $L_2$ may independently be selected from a single bond and -C=C-. Even more particularly, each $L_2$ may be a single bond.

In particular, the M group of the compounds of general formula (V) may represent 2 hydrogen atoms; or M may be selected from Zn, Mg, Al, Si, Cu, Ru and Ni; or M may be selected from $Sn(IV)(L)_2$, $P(V)(L)_2$, Au(III), Ru(II)LL', Ir(III) wherein L and L' represent axial ligands selected from halogeno, for example $Cl^-$, $Br^-$ or $I^-$; hydroxo ($OH^-$); alkoxide, for example $R'O^-$ wherein R' is alkyl or phenyl; carboxylato, for example $R'COO^-$ wherein R' is alkyl or phenyl; CO; and pyridine. More particularly, M may be selected from Zn, Mg and Cu; or M may be seleced from $Sn(IV)(L)_2$, $P(V)(L)_2$ and Au(III).

In particular, n is 0 or 1 and depends on the nature of M. As such, n is 1 when M is Au(III) or Ir(III). Otherwise, n is 0.

As such, the compounds of the second embodiment of the present invention may correspond to general formula (V) wherein

$R_1$-$R_{16}$ are each independently selected from H, $C_1$-$C_6$-alkyl and $C_6$-aryl;

D and G are each independently selected from H, $C_1$-$C_6$-alkyl, $C_6$-aryl, di-$C_1$-$C_6$-alkyl amino, di-$C_6$-aryl amino, tri-$C_6$-aryl amino and di-$C_1$-$C_6$-alkyl-$C_6$-aryl amino, thienyl, oligothienyl, and combinations thereof; in particular phenyl, diphenyl amino and triphenylamino; wherein said groups may optionally be substituted by one or two substituents selected from alkyl, alkoxy, phenoxy, dialkylamino, diphenylamino, thioether, carboxylic group and sulfonic group;
E and F are each independently selected from $C_6$-arylene, 5- to 20-membered heteroarylene, -C=C-, -CH=CH-, and combinations thereof; in particular phenylene, thiendiyl, benzothiadiazoldiyl, benzotriazoldiyl, pyridindiyl, triazoldiyl, -C=C-, -CH=CH-, and combinations thereof;
$L_2$ are each independently selected from a single bond, -C=C- and -CR=CR-, wherein R is H or -CN;
M represents 2 hydrogen atoms; or M is selected from Sn(IV)$(L)_2$, P(V)$(L)_2$, Au(III), Ru(II)LL', Ir(III) wherein L and L' represent axial ligands selected from halogeno, for example $Cl^-$, $Br^-$ or $I^-$; hydroxo ($OH^-$); alkoxide, for example $R'O^-$ wherein R' is alkyl or phenyl; carboxylato, for example $R'COO^-$wherein R' is alkyl or phenyl; CO; and pyridine; in particular Sn(IV)$(L)_2$, P(V)$(L)_2$, Au(III);
n is 0 or 1.

Such compounds are considered as Donor-Acceptor-Donor compounds (D-A-D) wherein the central diazaporphyrin core is an electron acceptor and the D and G groups are electron donors.

In a particularly preferred embodiment of the present invention, the D-A-D compound of formula (V) is:

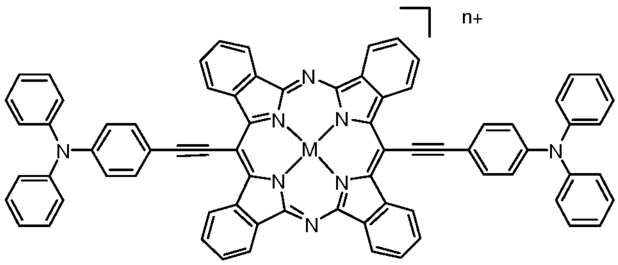

wherein M is Sn(IV)$(L)_2$ and n is 0, or M is P(V)$(L)_2$ and n is 0, or M is Au(III) and n is 1, or M is Ru(II)LL' and n is 0, or M is Ir(III) and n is 1;
wherein L is selected from $Cl^-$, $Br^-$, $I^-$, $OH^-$, $R'O^-$ and $R'COO^-$ with R' is alkyl or phenyl; and
wherein L' is selected from CO and pyridine.

Compounds of the second embodiment of the present invention may also correspond to general formula (V) wherein
$R_1$-$R_{16}$ are each independently selected from H, $C_1$-$C_6$-alkyl and $C_6$-aryl;
D and G are each independently selected from H, $C_6$-aryl, 5- to 20-membered heteroaryl, alkenyl, and combinations thereof; in particular phenyl, thienyl optionally fused with an *N*-alkyl pyrrolidine-2,5-dione, benzothiadiazolyl optionally fused with a 2-alkyl triazole, benzotriazolyl, pyridinyl, triazolyl, phthalimidyl, a pyridinium radical, a diketopyrrolopyrrole radical, an isoindigo radical, a *N*-alkyl-2,2'-bithiophene-3,3'-dicarboximide radical, dicyanovinyl, tricyanovinyl, and combinations thereof;
E and F are each independently selected from $C_6$-arylene, 5- to 20-membered heteroarylene, -C=C-, -CH=CH-, and combinations thereof; in particular phenylene, thiendiyl, benzothiadiazoldiyl, benzotriazoldiyl, pyridindiyl, triazoldiyl, -C=C-, -CH=CH-, and combinations thereof;
$L_2$ are each independently selected from a single bond, -C=C- and -CR=CR-, wherein R is H or -CN;
M represents 2 hydrogen atoms; or M is selected from Zn, Mg, Al, Si, Cu, Ru and Ni; in particular Zn, Mg and Cu; preferably Zn; and
n is 0.

Such compounds are considered as Acceptor-Donor-Acceptor compounds (A-D-A) wherein the central diazaporphyrin core is an electron donor and the D and G groups are electron acceptors.

In a particularly preferred embodiment of the present invention, the A-D-A compound of formula (V) is:

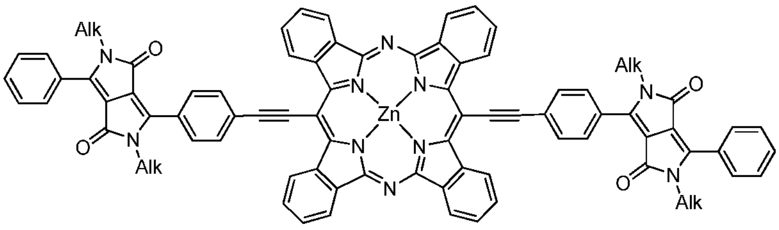

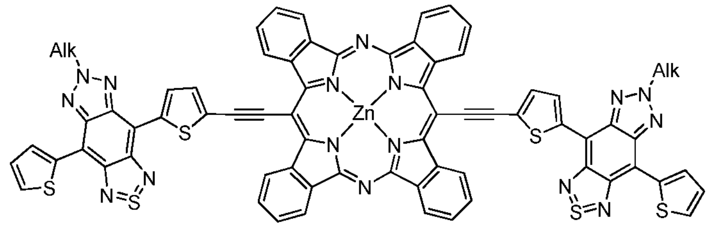

.

Compounds represented by formula (I) may be prepared according to various methods well known in the art. For example, said compounds may be prepared according to the synthetic route detailed in Figures 1 and 2.

**Dye-sensitized solar cell (DSSC)**

The present invention also relates to a dye-sensitized solar cell (DSSC) comprising a compound of general formula (II) as defined herein.

The DSSC of the present invention comprises an anode, a counter-electrode, a nanocrystalline semiconductor, a sensitizer and an electrolyte.

In a preferred embodiment, the DSSC comprises an anode onto which is deposited a nanocrystalline semiconductor. The sensitizer is adsorbed on said nanocrystalline semiconductor. The DSSC further comprise a counter-electrode onto which is spread the electrolyte. The anode and counter-electrode are joined and sealed together to prevent the electrolyte from leaking.

The anode of the DSSC of the present invention may be a transparent material, for example glass or a transparent polymer such as polyethylene terephthalate or polyethersulfone, doped with a semiconductor, for example indium tin oxide (ITO), tin oxide ($SnO_2$), fluoride-doped tin dioxide (FTO) and mixtures thereof. For example, the substrate may be a glass plate coated with one or two layers of semiconductor selected from IOT, $SnO_2$, FTO and mixtures thereof.

The nanocrystalline semiconductor of the DSSC of the present invention may comprise a metal oxide. In particular, said metal oxide may be selected from titanium dioxide, tin oxide, zinc oxide, tungsten oxide, zirconium oxide, gallium oxide, indium oxide, yttrium oxide, niobium oxide, tantalum oxide, vanadium oxide, and mixtures thereof. More particularly, said metal oxide may be selected from titanium dioxide, tin oxide, zinc oxide, indium oxide, and mixtures thereof, preferably titanium dioxide.

Said nanocrystalline semiconductor can be in the form of a nanostructured film. By "nanostructured film" it is meant a film of nanoparticles having a diameter from 1 to 500 nm. As such, in a particularly preferred embodiment, the nanocrystalline semiconductor is a nanostructured $TiO_2$ film.

For example, the nanocrystalline semiconductor can be a nanostructured $TiO_2$ film comprising $TiO_2$ nanoparticles that exhibit a diameter of 10 to 30 nm; in particular 15 to 25 nm; more particularly 20 nm. Said nanostructured $TiO_2$ film can exhibit a thickness of 7 to 25 $\mu$m; in particular 10 to 20 $\mu$m; more particularly 12 to 15 $\mu$m.

According to an embodiment, the nanocrystalline semiconductor of the DSSC can comprise a plurality of nanostructured $TiO_2$ layers. In particular, the DSSC can comprise a plurality of $TiO_2$ layers that do not exhibit the same particle diameter. More particularly, the DSSC can comprise a first layer of $TiO_2$ on the substrate and a second layer of $TiO_2$ on said first layer, wherein the diameter of the $TiO_2$ nanoparticles of the second layer is higher than the diameter of the $TiO_2$ nanoparticles of the first layer. Indeed, adding a second $TiO_2$ layer with larger particle size on the first $TiO_2$ layer can increase the solar efficiency of the DSSC because the second layer with larger particle size increases the light scattering of the semiconductor.

For example, the first $TiO_2$ layer can be a nanostructured $TiO_2$ film comprising $TiO_2$ nanoparticles that exhibit a diameter of 10 to 30 nm; in particular 15 to 25 nm; more particularly 20 nm; and the second $TiO_2$ layer can be a nanostructured $TiO_2$ film comprising $TiO_2$ nanoparticles that exhibit a diameter of 100 to 300 nm; in particular 150 to 250 nm; more particularly 200 nm.

The thickness of the second $TiO_2$ layer may be lower than the thickness of the first $TiO_2$ layer. For example, the first $TiO_2$ lay can exhibit a thickness of 7 to 25 $\mu$m, in particular 10 to 20 $\mu$m, more particularly 12 to 15 $\mu$m and the second $TiO_2$ layer can exhibit a thickness of 1 to 6 $\mu$m, in particular 2 to 5 $\mu$m, more particularly 3 to 4 $\mu$m.

Said nanocrystalline semiconductor can be formed on the anode by any means known in the art, for example by spraying metal oxide nanoparticles to form a film thereof directly on the anode; by electrically depositing a film of metal oxide nanoparticles on the anode; by applying a slurry or paste comprising metal oxide nanoparticles in a dispersion medium, for example with the "doctor-blade" technique, and drying, curing and/or sintering.

The sensitizer of the DSSC of the present invention is adsorbed onto the nanocrystalline semiconductor. Said sensitizer comprises a compound of general formula (II) as defined herein.

The sensitizer may further optionally comprise an additional organic dye or a metal complex dye. Indeed, combining the compound of general formula (II) with an additional dye can advantageously broaden the absorption spectra of the resulting DSSC. In particular, said metal complex dye may be selected from a ruthenium complex or quaternary salt thereof, a phthalocyanine, a porphyrin. Furthermore, said organic dye may include metal-free phthalocyanine, porphyrin, cyanine, merocyanine, oxonol, or triphenylmethane dye, methyne dye such as acrylate dyes described in European Patent Application n°1,311,001, xanthenes, azo, anthraquinone and perylene dye.

The sensitizer may further optionally comprise a co-adsorbate. Said co-adsorbate advantageously prevents aggregation of the compound of general formula (II) which results in an increase of the injection quantum yield. The co-adsorbate may be selected from deoxycholic acid, dehydrodeoxycholic acid, chenodeoxycholic acid, cholic acid methyl ester, cholic acid sodium, polyethyleneoxides, crown ethers, cyclodextrins, calixarenes, polyethyleneoxides, and mixtures thereof. In particular, said co-adsorbate may be chenodesoxycholic acid.

The sensitizer may be adsorbed on the nanocrystalline semiconductor by any known method in the art. For example, the sensitizer may be chemisorbed on the nanocrystalline semiconductor by immersing said nanocrystalline semiconductor in a liquid comprising the sensitizer solubilized or dispersed in a suitable medium. Said medium may be selected from water, methanol, ethanol, toluene, acetonitrile, dichloromethane, dimethylsulfoxide, dimethylformamide, acetone, tert-butanol, and mixtures thereof. In particular, said medium may be a mixture of water and toluene. In case the sensitizer comprises a compound of general formula (II) and an additional organic dye or a metal complex dye, they may be sequentially absorbed on the nanocrystalline semiconductor, or mixed and absorbed conjunctively.

The counter-electrode of the DSSC of the present invention may comprise a material selected from platinum, poly(3,4-ethylenedioxythiophene) (PEDOT) and glassy carbon (GC).

The electrolyte may comprise an organic solvent and a redox couple. In particular, the solvent of the electrolyte may be selected from acetonitrile, propylene carbonate, ethylene carbonate, 3-methoxypropionitrile, methoxy acetonitrile, valeronitrile, ethylene glycol, propylene glycol, diethylene glycol, triéthylène glycol, butyrolactone, dimethoxyethane, dimethyl carbonate, 1,3-dioxolane, methylformate, 2-methyltetrahydrofurane, 3-methoxy-oxazolidin-2-one, sulforane, tetrahydrofurane, water, and mixtures thereof. In particular, said solvent may be acetonitrile.

The redox couple of the electrolyte may comprise a halide source and a halogen molecule, preferably an iodide source and iodine. The iodide source may be selected from an iodide metal salt, a tetraalkylammonium iodide, an imidazolium iodide, a pyridinium iodide, and mixtures thereof. In particular, said iodide source may be LiI, NaI, KI, $CaI_2$, $MgI_2$, CuI, tetramethylammonium iodide (TMAI), tetrabutylammonium iodide (TBAI), 1-methyl-3-propylimidazolium iodide, 1,2-dimethyl-3-butylimidazolinium iodide (DMBIM), and mixtures thereof. More particularly said halide source may be selected from LiI, 1,2-dimethyl-3-butylimidazolinium iodide, and mixtures thereof.

The electrolyte may further optionally comprise an additive selected from tert-butyl pyridine (TBP), bis(trifluoromethane)sulfonimide lithium (LiTFSI), and mixtures thereof.

**Organic solar cell (OSC)**

The present invention also relates to an organic solar cell (OSC) comprising a compound of general formula (V) as defined herein.

The OSC of the present invention comprises an anode, a cathode and a sensitizer.

In a preferred embodiment, the OSC comprises a layer of sensitizer sandwiched between the cathode and the anode.

The cathode of the OSC of the present invention may comprise a material selected from indium tin oxide (ITO), fluorine tin oxide (FTO), graphene, and mixtures thereof; said material optionally comprising a thin layer of selective hole extracting material such as, for example, poly(3,4-ethylenedioxythiophene) polystyrene sulfonate (PEDOT:PSS), molybdenum oxide ($MoO_x$), tungsten oxide ($WO_x$), nickel oxide ($NiO_x$) or vanadium oxide ($V_2O_x$), for direct solar cells.

The anode of the OSC of the present invention may comprise a material selected from Al, Ag, Cu, Au, and mixtures thereof, said material optionally comprising a thin layer of selective electron extracting material such as bathocuproine or lithium fluoride (LiF) for direct cells or ITO or FTO transparent conducting electrode coated with a layer of $TiO_x$ or ZnO for inverted solar cells.

The sensitizer of the OSC of the present invention comprises a compound of general formula (V) as defined herein.

The sensitizer may further optionally comprise an additional organic dye or a metal complex dye. Indeed, combining the compound of general formula (II) with an additional dye can advantageously broaden the absorption spectra of the resulting OSC. In particular, said metal complex dye may be selected from a ruthenium complex or quaternary salt thereof, a phthalocyanine, a porphyrin. Furthermore, said organic dye may include metal-free phthalocyanine, porphyrin, cyanine, merocyanine, oxonol, or triphenylmethane dye, methyne dye such as acrylate dyes described in European Patent Application EP 1,311,001, xanthenes, azo, anthraquinone, perylene dye (as described, for example by Nazeeruddin M. K., in Journal of the American Chemical Society (1993), Vol. 115, p. 6382-6390) or a triphenylamine based dye such as D35 ((E)-3-(5-(4-(bis(2',4'-dibutoxy-[1,1'-biphenyl]-4-yl)amino)phenyl)thiophen-2-yl)-2-cyanoacrylic acid).

The sensitizer may further optionally comprise a co-adsorbate. Said co-adsorbate advantageously prevents aggregation of the compound of general formula (II) which results in an increase of the injection quantum yield. The co-adsorbate may be selected from deoxycholic acid, dehydrodeoxycholic acid, chenodeoxycholic acid, cholic acid methyl ester, cholic acid sodium, polyethyleneoxides, crown ethers, cyclodextrins, calixarenes, polyethyleneoxides, and mixtures thereof. In particular, said co-adsorbate may be chenodesoxycholic acid.

The OSC may be made by coating the anode or the cathode with the sensitizer, for example by spin-coating, and by combining the anode and cathode.

## Use of sensitizers in solar cells

The compounds of general formula (I) may be used in solar cells.

In particular, the compounds of general formula (II) may be used as a sensitizer in a dye-sensitized solar cell as disclosed herein.

In another embodiment, the compounds of general formula (V) may be used as a sensitizer in an organic solar cell as disclosed herein.

This invention will be further illustrated by the following non-limiting examples which are given for illustrative purposes only and should not restrict the scope of the appended claims.

## EXAMPLES

### Example 1: Synthesis of CROSSDAP

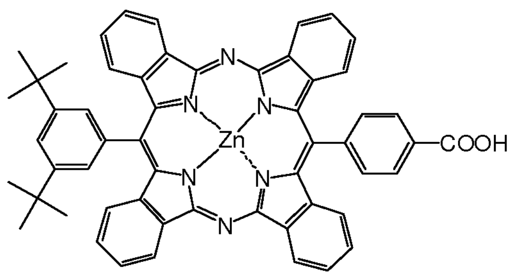

Figure 1 shows the synthetic route for the preparation of **CROSSDAP.**

The starting dihydroisoindole *tert*-butyl ester **1** was prepared according to the procedure described in Cheprakov, A.V. and M.A. Filatov, The dihydroisoindole approach to linearly annelated $\pi$-extended porphyrins. Journal of Porphyrins and Phthalocyanines, 2009. 13(03): p. 291-303.

### General procedure for preparation of meso-aryl substituted dibenzodipyrromethenes 4 and 9

Two equivalents of 4,7-dihydroisoindole **1** and one equivalent of a corresponding aryl aldehyde **2** or **7** were dissolved in dry dichloromethane. *Para*-toluene sulfonic acid (TsOH) (0.1 equivalent) and tetrabutylammonium bromide ($Bu_4NBr$) (10 equivalents) were then added to the solution and stirred for 24 h at room temperature. Saturated aqueous $NaHCO_3$ was added to the solution and stirred vigorously for 10 min. The organic layer was separated, washed with water, dried and evaporated to afford an orange solid.

The solid residue was dissolved in toluene, 3 equivalents of 2,3-dichloro-5,6-dicyanoquinone (DDQ) was added

and the solution was stirred for 2 hours at ambient temperature. 10% aqueous solution of $Na_2SO_3$ was added and stirred vigorously for 10 min. Most toluene was removed under reduced pressure, the residue was diluted by dichloromethane, organic layer was extracted, washed with water, dried and concentrated *in vacuo.* The residual solution was applied to a column silica gel column, eluted with dichloromethane, a deep-violet fraction was collected and solvent removed under reduced pressure.

***Meso*-(3,5-di-*tert*-butylphenyl)-dibenzodipyrromethene 4:**

Were used 0.4 g of 4,7-dihydroisoindole **1**, 0.2 g of 3,5-di-*tert*-butyl benzaldehyde **2** and 0.6 g of DDQ during the oxidation stage.
Yield 0.42 g (73%) of a dark solid. M.p. 200°C with decomposition.
$^1$H NMR ($CDCl_3$, 400 MHz): 14.74 (br. s., 1H), 8.15 (d., *J* = 8.08 Hz, 2H), 7.24 (t., *J* = 7.43 Hz, 2H), 7.04 (t., *J*=7.43 Hz, 2H), 6.78 (br. s., 1H), 6.69 (br. s., 2H), 6.39 (d., *J*=8.08 Hz, 2H), 1.57 (s. 18H) 1.76 (s., 18H).
$^{13}$C NMR ($CDCl_3$): 161.63, 149.71, 147.87, 142.44, 141.33, 138.97, 135.64, 131.33, 125.67, 123.53, 122.70, 122.42, 107.56, 101.73, 81.10, 55.62, 27.82.
MALDI-TOF (1,8-bis(diphenylamino)-naphthalene , negative ion), *m/z* 631.54 $(M-H)^-$.

**Meso-(4-methoxycarbonylphenyl)-dibenzodipyrromethene 9:**

Were used 0.5 g of a 4,7-dihydroisoindole **1,** 0.19 g of p-methoxycarbonyl benzaldehyde **7** and 0.75 g of DDQ at the oxidation stage.
Yield 0.58 g (87%) of a dark solid.
M.p. 147°C with decomposition.
$^1$H NMR ($CDCl_3$, 400 MHz): 14.79 (br. s., 1H), 8.36 (d., *J*= 8.08 Hz, 2H), 8.16 (d., *J*= 8.08 Hz, 2H), 7.66 (d., *J* = 8.08 Hz, 2H), 7.23 (t., *J* = 7.33 Hz, 2H), 6.97 (t., *J*=7.33 Hz, 2H), 6.09 (d., *J*=8.08 Hz, 2H), 4.08 (s., 3H) 1.78 (s., 18H).
$^{13}$C NMR ($CDCl_3$): 166.71, 161.00, 141.38, 139.56, 137.50, 135.48, 133.98, 131.38, 131.14, 130.68, 129.63, 126.93, 125.92, 123.07, 121.73, 82.55, 52.54, 28.39.
MALDI-TOF (1,8-bis(diphenylamino)-naphthalene, negative ion), *m/z* 577.86 $(M-H)^-$.

**General procedure for preparation of azides 6 and 11:**

Dipyrromethene **4** or **9** (0.35 g) was dissolved in trifluoroacetic acid (TFA), stirred for 30 min at room temperature and the solvent was evaporated. The corresponding dibenzodepirromethene acid **5** or **10** was precipitated from diethyl ether and dried.

Excess of thionyl chloride ($SOCl_2$) was added to the dry dibenzodipyrrin acid **5** or **10,** stirred for 30 min at 30°C and evaporated under reduced pressure. The solid residue was dissolved in dry dichloromethane and excess of tetrabutylammonium azide ($Bu_4NN_3$) was added to the solution. The mixture was stirred for 1 h, washed with water, dried and concentrated *in vacuo.* The residue was passed through a column with silica, collecting a blue fraction and evaporated to dryness.

**Azide 6:**

Yield 0.25 g (70%) of a dark solid.
M.p. 120°C with decomposition.
$^1$H NMR ($CDCl_3$, 400 MHz): 14.72 (s, 1H), 8.23 (d, *J*=8.08 Hz, 2H), 7.74 (t, *J*=1.77 Hz, 1H) 7.39 (d, *J*=1.77 Hz, 2H), 7.29 (ddd, *J*=7.53, 1.01 Hz, 2H), 7.01 (ddd, *J*=7.71, 1.01 Hz, 2H), 6.17 (d, *J*=8.34 Hz, 2H), 1.37 (s, 18H).
$^{13}$C NMR ($CDCl_3$) 166.2, 152.4, 138.1, 137.1, 135.9, 134.7, 131.9, 127.3, 126.9, 123.4, 122.7, 122.5, 35.2, 31.4.
MALDI-TOF (dithranol), *m/z* 514.3 $(M-2N_2)^+$, 515.3 $(MH-2N_2)^+$.

**Azide 11:**

Yield 0.25 g (65%) of a dark solid.
M.p. 120°C with decomposition.
MALDI-TOF (dithranol), *m/z* 460.2 $(M-2N_2)^+$, 461.2 $(MH-2N_2)^+$.

**5,15-diaryl-10,20-diazaterabenzoporphrin 12:**

An equimolar mixture of azide **11** (0.042 g) and **6** (0.053 g) was refluxed in DMF for 15 min. Dichloromethane

was then added and the reaction mixture was washed with water and evaporated to dryness. Porphyrinoid **12** was isolated as an intermediate green fraction by column chromatography on silica.
Yield 0.012 g (15%) of a deep-green crystalline solid.
M.p >300°C.
$^1$H NMR ($CDCl_3$, 400 MHz): 9.69 (d., *J*=7.58 Hz, 2H), 9.62 (d., *J*=7.58 Hz, 2H), 8.59 (d., *J*=8.19 Hz, 2H), 8.20 (m., 4H), 8.14 (s., 1H), 8.05 (d., *J*=7.34 Hz, 2H), 7.93 (t., *J*=7.34 Hz, 2H), 7.73 (t., *J*=7.82 Hz, 2H), 7.60 (t., *J*=7.82 Hz, 2H), 7.29 (d., *J*=6.48 Hz, 2H), 7.00 (d., *J*=7.95 Hz, 2H), 7.24 (s., 3H), 1.62 (s., 18H), -1.25 (br. s., 1H), -1.37 (br. s., 1H).
MALDI-TOF (1,8-bis(diphenylamino)-naphthalene), *m/z* 834.72 $(M-H)^-$.

**CROSSDAP:**

The mixture of diaryldiazatetrabenzoporphyrin **12** (0.02 g) with excess of $Zn(OAc)_2$ dihydrate was refluxed in DMF for 2 h. The reaction mixture was diluted with dichloromethane, washed with water, dried and evaporated to dryness. The residue was dissolved in concentrated solution of potassium hydroxide in methanol and stirred for 30 min at room temperature. The reaction mixture was diluted by water, precipitate was centrifuged, washed by 0.5M HCl, water and centrifuged again to afford deep-green crystalline solid.
Yield 0.02 g (95%).
$^1$H NMR ($THFd^8$+5%$CD_3OD$, 300 MHz): 9.72 (d., *J*=6 Hz, 2H), 9.70 (d., *J*=6 Hz, 2H), 8.72 (br. s., 2H), 8.33 (d., *J*=6Hz, 2H), 8.18 (t., *J*=*3* Hz, 1H), 8.11 (d., *J*=3 Hz, 2H), 7.97 (t., *J*=7.34 Hz, 4H), 7.63 (m., 4H), 7.21 (d., *J*=6 Hz, 2H), 1.55 (s., 18H).

MALDI-TOF (1,8-bis(diphenylamino)-naphthalene, negative ion), *m/z* 881.6 $(M-H)^-$.
High resolution ESI-MS: calculated for $C_{55}H_{42}N_6O_2Zn$ 882.26552, found 882.26392.

**Example 2: Synthesis of TPA-CROSSDAP**

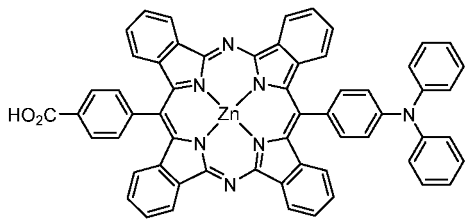

**TPA-CROSSDAP**

Figure 2 shows the synthetic route for the preparation of **TPA-CROSSDAP.**

**Meso-(4-diphenylamino-phenyl)-dibenzodipyrromethene 16:**

Dibenzodipyrromethene **16** was prepared following the general procedure for preparation of meso-aryl substituted dibenzodipyrromethenes **4** and **9** of example 1.

Were used 0.35 g of a dihydroisoindole **1,** 0.22 g of 4-diphenylaminobenzaldehyde **14** and 0.6 g of DDQ during the oxidation stage.
Yield 0.35 g (71%) of a dark solid.
M.p. 200°C with decomposition.
$^1$H NMR ($CDCl_3$, 400 MHz): 8.64 (d., *J*=8.07 Hz, 2H), 7.40-7.28 (m., 14H), 7.15 (m., 4H), 6.57 (d., *J*=8.19 Hz, 2H), 4.13 (s., 6H).
MALDI-TOF (1,8-bis(diphenylamino)-naphthalene, negative ion), *m/z* 602.44 $(M-H)^-$.

**Azide 18:**

Azide **18** was prepared following the general procedure for preparation of azides **6** and **11** of example 1.
Yield 0.25 g (70%) of a dark solid.
M.p. 120°C with decomposition.
MALDI-TOF (dithranol), *m/z* 569.3 $(M-2N_2)^+$, 570.3 $(MH-2N_2)^+$.

**5,15-diaryl-10,20-diazatetrabenzoporphyrin 19:**

An equimolar mixture of azides **18** (0.042 g) and **11** (0.053 g) was refluxed in propylene glycol for 20 min. Dichloromethane was then added and the reaction mixture was washed with water and evaporated to dryness. Porphyrinoid **19** was isolated as an intermediate green fraction by column chromatography on silica.
Yield 0.001 g (1%) of a deep-green crystalline solid.
M.p >250°C.
MALDI-TOF (1,8-bis(diphenylamino)-naphthalene), *m/z* 888.53 $(M-H)^-$.

**TPA-CROSSDAP:**

The mixture of diaryldiazatetrabenzoporphyrin **19** (0.004 g) with excess of $Zn(OAc)_2$ dihydrate was refluxed in DMF for 30 min. The reaction mixture was diluted with dichloromethane, washed with water, dried and evaporated to dryness. The residue was dissolved in concentrated solution of potassium hydroxide in methanol and stirred for 30 min at room temperature. The reaction mixture was diluted by water, precipitate was centrifuged, washed by 0.5M HCl, water and centrifuged again to afford deep-green crystalline solid.
MALDI-TOF (1,8-bis(diphenylamino)-naphthalene, negative ion), *m/z* 936.7 $(M-H)^-$.

**Example 3: Evaluation of electronic absorption and emission spectra of CROSSDAP and a precursor of TPA-CROSSDAP**

The electronic absorption and emission spectra of **CROSSDAP** are measured with a solution comprising 10 μM of **CROSSDAP,** in dimethylformamide as solvent.

The electronic absorption and emission spectra of the precursor of **TPA-CROSSDAP** are measured with a solution comprising 10 μM of 5,15-diaryl-10,20-diazatetrabenzoporphyrin **19,** in dichloromethane as solvent.

This solution is introduced into a quartz cell. The electronic absorption and emission spectra of **CROSSDAP** and the precursor of **TPA-CROSSDAP** in the wavelength domain were measured by a spectrophotometer and fluorimeter respectively.

Figure 3 shows the electronic absorption (straight line) and emission (dashed line) spectra of **CROSSDAP,** which clearly exhibits the intense absorption band at 685 nm with a high extinction coefficient ($\varepsilon = 9.3 \times 10^4\ M^{-1}cm^{-1}$).

Figure 4 shows the electronic (straight line) and emission (dashed line) spectra of the precursor of **TPA-CROSSDAP,** which clearly exhibits the intense absorption band at 685 nm with a high extinction coefficient ($\varepsilon = 9.33 \times 10^4\ M^{-1}cm^{-1}$).

**Example 4: Evaluation of the redox potential of CROSSDAP**

The redox potential of **CROSSDAP** was measured by cyclic voltammetry using 3 electrodes.

The 3 electrodes used are:

- 1 Platinum working electrode
- 1 Platinum auxiliary or counter electrode
- 1 saturated calomel electrode (SCE) as reference electrode.

The scan rate of the potential is fixed to 100mV/s.

The analysed solution comprises 0.001 M of **CROSSDAP** in acetonitrile as solvent and with 0.1 M of $Bu_4NPF_6$ as supporting electrolyte.

The indicated potential values are the first oxidation potentials for the compounds, with respect to the reference electrode (SCE).

It was found that:

$$E_{Ox1}(D^+/D) = 0.84\ V,$$

and

$$E_{Ox2}(D^{++}/D^+) = 1.05\ V$$

wherein

$E_{Ox1}(D^+/D)$ corresponds to the first oxidation potential of **CROSSDAP.**
$E_{Ox2}(D^{++}/D^+)$ corresponds to the second oxidation potential of **CROSSDAP.**

**Example 5: Evaluation of the electron injection and the dye regeneration of CROSSDAP**

By combining the emission wavelength of **CROSSDAP** as determined in example 2 and the redox potential of **CROSSDAP** as determined in example 3, the injection ($\Delta G_{inj}$) and the regeneration driving ($\Delta G_{reg}$) forces can be calculated according to the following equations:

$$\Delta G_{inj} = E_{Ox1}(D^+/D) - E_{00}(D^*) + 0.70 = 0.84 - 1.84 + 0.70 = -0.30 \text{ eV}$$

$$\Delta G_{reg} = E_{Ox}(I_2^{-\bullet}/I^-) - E_{Ox1}(D^+/D) = 0.55 - 0.84 = -0.29 \text{ eV}$$

wherein
$E_{Ox1}(D^+/D)$ corresponds to the first oxidation potential of **CROSSDAP** as determined in example 3;
$E_{00}(D^*)$ corresponds to the oxidation potential of **CROSSDAP** singlet excited state as determined by $E_{Ox1}(D^+/D^*) = E_{Ox1}(D^+/D) - E_{00}(D^*)$ with $E_{00}(D^*)$ determined by the wavelength at the intersection of the absorption and emission spectra (Figure 1).
$E_{Ox}(I_2^{-\cdot}/I^-)$ corresponds to the oxidation potential of $I_2^{-\cdot}/I^-$ taken as 0.55 V vs SCE as disclosed in G. Boschloo, E. A. Gibson and A. Hagfeldt J. Phys. Chem. Lett. 2011, 2, 3016-3020.

These calculations support that both electron injection and dye regeneration processes are very exergonic.

**Example 6: DSSC comprising CROSSDAP**

DSSCs were prepared according to the FTO conductive glass substrates (F-doped $SnO_2$) were purchased from Pilkington (TEC8). The plates were cleaned by successive sonication in soapy water, then an ethanolic solution of HCI (0.1 M) for 10 minutes, and finally dried in air. $TiO_2$ films were prepared in three steps. A first treatment is applied by immersion for 30 min in an aqueous $TiCl_4$ solution at 80°C. Three successive layers of mesoporous $TiO_2$ were then screen printed using a transparent colloidal paste (Dyesol DSL 18NR-T) and a final light scattering layer (Dyesol DSL 18NR-AO) was affixed, with 20-minute long drying steps at 150°C between each layer. The obtained substrates were then sintered at 450°C, following a progressive heating ramp (325°C for 5 min, 375°C for 5 min, 450°C for 30 min). A second $TiCl_4$ treatment was immediately conducted afterwards and the electrodes were fired one last time at 450°C for 30 minutes. Thicknesses (16 μm) were measured by a Sloan Dektak 3 profilometer. The prepared $TiO_2$ electrodes were soaked while still hot (ca. 80°C) in a 0.2 mM solution of **CROSSDAP** and chenodeoxycholic acid (5 mM) in a 1:1 mixture (v:v) of toluene and ethanol. After one night of dyeing at room temperature, the electrodes were rinsed in ethanol and dried in air, in the dark. Platinum based counter electrodes were prepared by drop casting two drops of hexachloroplatinic acid in distilled isopropanol (2 mg per mL) on FTO plates, and subsequent firing at 380°C for 30 minutes. The photoelectrode and the counter electrode were placed on top of each other and sealed using a thin transparent film of Surlyn polymer (DuPont, 60 μm) as a spacer. The resulting chamber was filled with an iodine-based electrolyte (30 mM $I_2$, 0.1 M LiI, 0.1 M guanidinium thiocyanate, 0.6 M 1-ethyl-2,3-dimethylimidazolium iodide and 0.6 M 4-tertbutylpyridine when mentioned, in dry distilled acetonitrile) by vacuum back filling through a predrilled hole in the counter electrode, and the photovoltaic device was sealed afterwards with Surlyn and a cover glass. The cell had an active area of 0.25 $cm^2$. Photovoltaic measurements were performed with a calibrated AM 1.5 artificial solar light simulator (Oriel) and a Keithley 2400 digital source-meter; data were collected with a local software designed by Synervia (labview).

The photovoltaic characteristics of the DSSCs were recorded under calibrated Air mass 1.5 spectrum (AM1.5) simulator at 1000 $W/m^2$ and are depicted in Figure 5. The mean metrics of at least 3 independent solar cells are: Jsc= 7.73 $mA/cm^2$; Voc= 597 mV, ff= 74% leading to a PCE of 3.45%, wherein:

Jsc is the short-circuit current density;
Voc is the open-circuit voltage
ff is fill factor; and
PCE is the photoconversion efficiency.

Figure 5 shows the current/voltage characteristic of the solar cell sensitized with **CROSSDAP** recorded under

the dark (dashed line) and under AM 1.5 illumination (straight line). The demonstrated efficiency of 3.45% in a non-optimized solar cell underscores the great potential of compounds of general formula (I) as sensitizers in solar cells.

The photoaction spectrum of the DSSC cell sensitized with **CROSSDAP** is given in Figure 6 and underscores the great photoactivity of this sensitizer in the near infrared region.

## Claims

1. Compound of general formula (I):

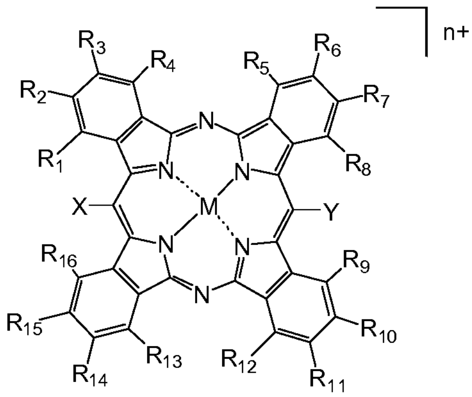

(I)

wherein

$R_1$-$R_{16}$ are each independently selected from H, alkyl and aryl; or two adjacent $R_1$-$R_{16}$ groups optionally form, together with the carbon atoms to which they are attached, a ring selected from cycloalkyl and aryl, and the remaining $R_1$-$R_{16}$ groups are each independently selected from H, alkyl and aryl;
X and Y, similar or different, each comprise at least one group selected from H, alkyl, aryl, arylene, heteroaryl, heteroarylene, alkendiyl, alkyndiyl, dialkyl amino, diaryl amino, triaryl amino and dialkylaryl amino;
M represents 2 hydrogen atoms; or M is selected from Zn, Mg, Al, Si, Cu, Ru, Au, Sn, Pd, Pt, Ir and Ni; or M is selected from $Sn(IV)(L)_2$, $P(V)(L)_2$, Au(III), Ru(II)LL', Ir(III) wherein L and L' represent axial ligands selected from halogeno, hydroxo, alkoxide, carboxylato, CO and pyridine; and
n is 0 or 1;
with the proviso that X and Y are not both H, or both alkyl or both aryl.

2. Compound according to claim 1, wherein said compound corresponds to general formula (II):

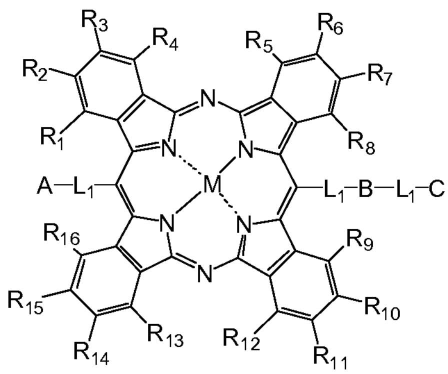

(II)

wherein

$R_1$-$R_{16}$ are each independently selected from H, alkyl and aryl; or two adjacent $R_1$-$R_{16}$ groups optionally form, together with the carbon atoms to which they are attached, a ring selected from cycloalkyl and aryl, and the remaining $R_1$-$R_{16}$ groups are each independently selected from H, alkyl and aryl;
A is selected from H, alkyl, aryl, dialkyl amino, diaryl amino, triaryl amino, dialkylaryl amino, thienyl, oligothienyl, and combinations thereof;
B is selected from arylene, heteroarylene, alkendiyl, alkyndiyl and combinations thereof;
C is selected from $-COOR_a$, $-COO^-$, $-PO_3H_2$, $-PO(OH)R_b$, $-CH=C(COOH)_2$, -CH=C(CN)(COOH), $-Si(OR_b)_3$, and $-C(O)-CH_2-C(O)-CH_3$ wherein $R_a$ is H, alkyl, amino, dialkylamino, diaryl amino or $-C(O)-R_b$ and wherein $R_b$ is alkyl;
$L_1$ are each independently selected from a single bond, $-(C{\equiv}C)_m-$, and $-(CH=CH)_o-$, wherein m and o are integers independently equal to 1, 2 or 3;
M represents 2 hydrogen atoms; or M is selected from Zn, Mg, Al, Si, Cu, Ru, Au, Sn, Pd, Pt, Ir and Ni.

**3.** Compound according to claim 2, wherein
$R_1$-$R_{16}$ are each independently selected from H, $C_1$-$C_6$-alkyl and $C_6$-aryl;
A is selected from H, $C_1$-$C_6$-alkyl, $C_6$-aryl, di-$C_1$-$C_6$-alkyl amino, di-$C_6$-aryl amino, tri-$C_6$-aryl amino, di-$C_1$-$C_6$-alkyl-$C_6$-aryl amino, thienyl, oligothienyl, and combinations thereof;
B is selected from $C_6$-arylene, 5- to 10-membered heteroarylene, -C=C-, -CH=CH- and combinations thereof; in particular B is selected from phenylene, thiendiyl, benzothiadiazoldiyl, benzotriazoldiyl, pyridindiyl, triazoldiyl, -C=C-, -CH=CH-, and combinations thereof;
C is selected from -COOH, $-PO_3H_2$, -CH=C(CN)(COOH), $-Si(OMe)_3$, $-Si(OEt)_3$ and $-C(O)-CH_2-C(O)-CH_3$;
$L_1$ are each independently selected from a single bond, -C=C- and -CH=CH-;
M represents 2 hydrogen atoms; or M is selected from Zn, Mg, Al, Si, Cu, Ru and Ni; in particular Zn, Mg and Cu; preferably Zn.

**4.** Compound according to claim 2 or 3, wherein said compound corresponds to general formula (III) or (IV):

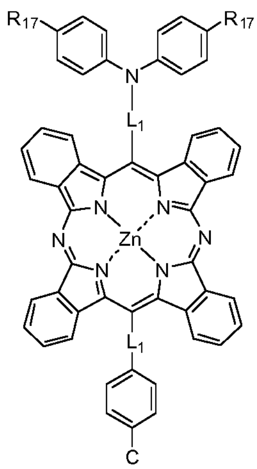
(III)

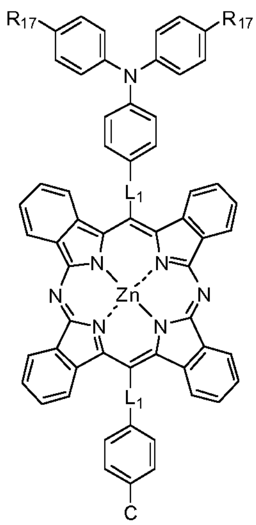
(IV)

wherein

$R_{17}$ is independently selected from H, alkoxy and phenyl substituted by one or two alkoxy groups;
$L_1$ is independently selected from bond and -C=C-; and
C is independently selected from -COOH and -CH=C(CN)(COOH).

**5.** Compound according to any one of claims 2 to 4, wherein said compound is selected from the following compounds:

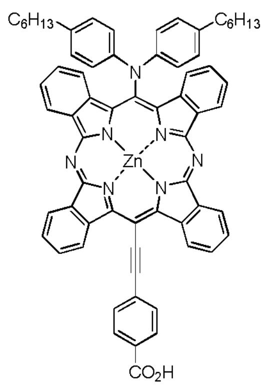,

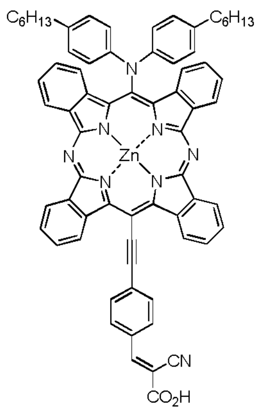,

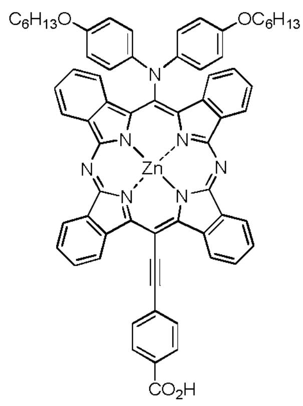,

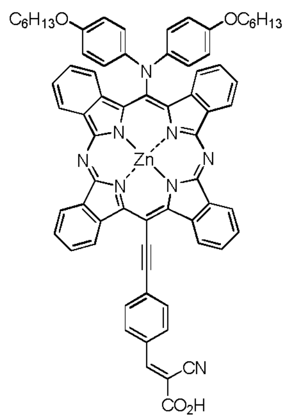

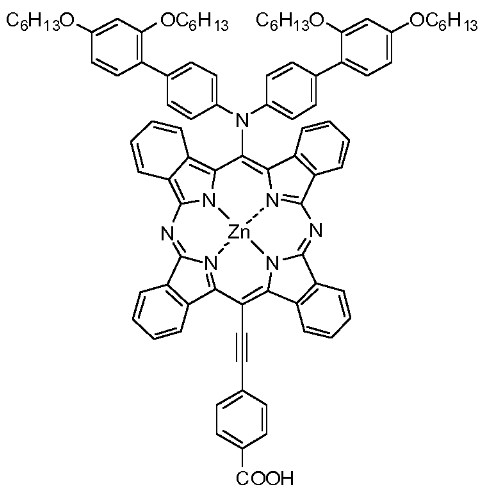,

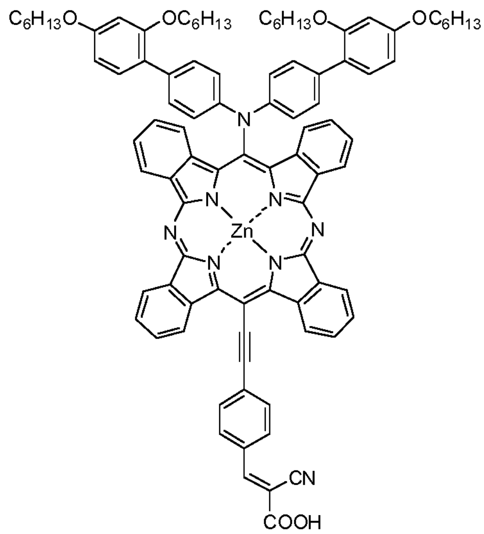,

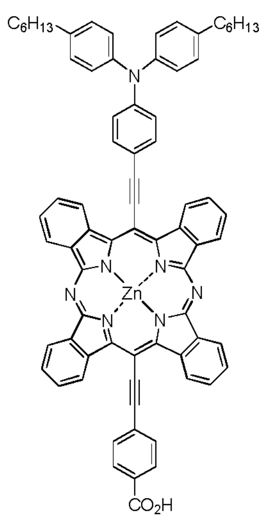,

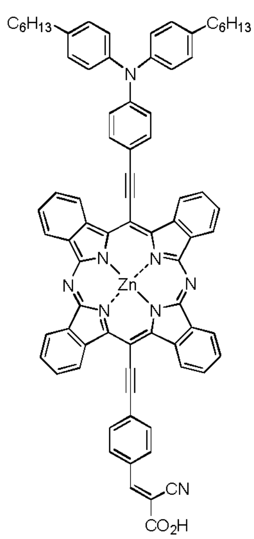,

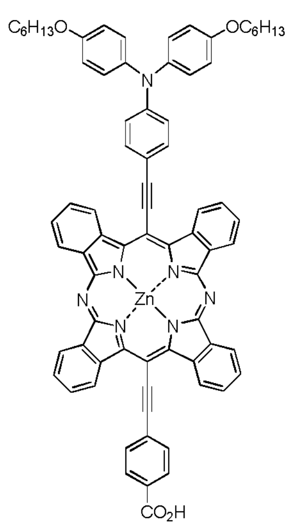,

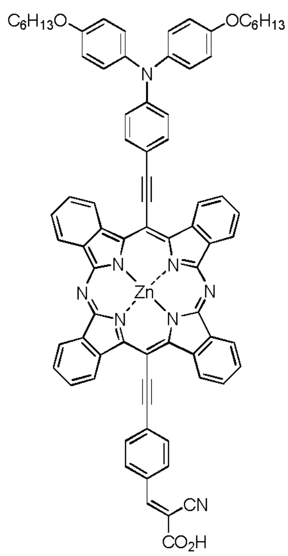,

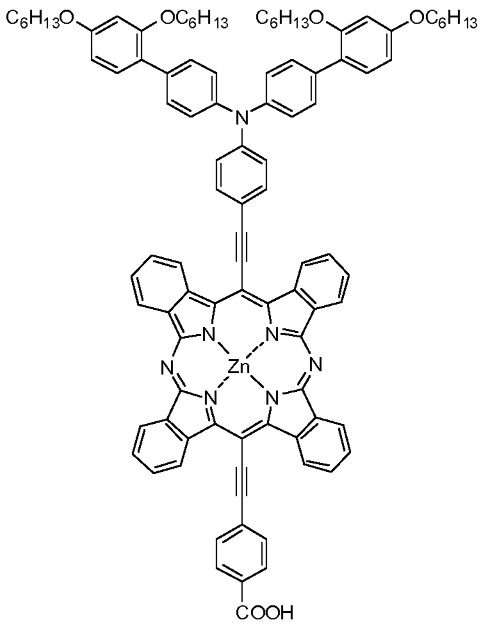

,

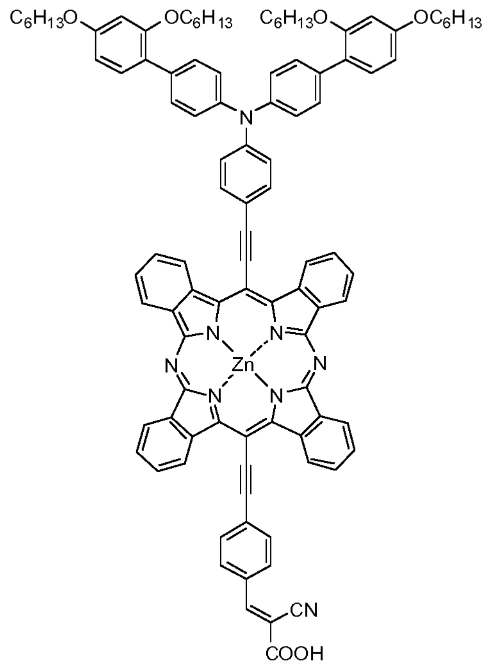

,

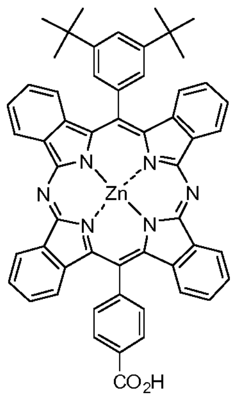

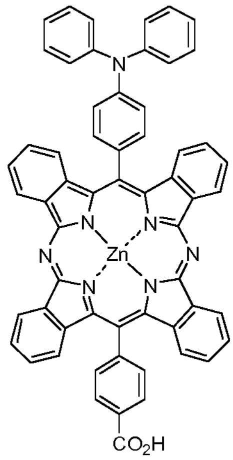

**CROSSDAP** , **TPA-CROSSDAP** .

6. Dye-sensitized solar cell comprising an anode, a counter-electrode, a nanocrystalline semiconductor, a sensitizer and an electrolyte, wherein the sensitizer comprises a compound as defined in any one of claims 2 to 5.

7. Use of a compound as defined any one of claims 2 to 5 as a sensitizer for a dye-sensitized solar cell.

8. Compound according to claim 1, wherein said compound corresponds to general formula (V):

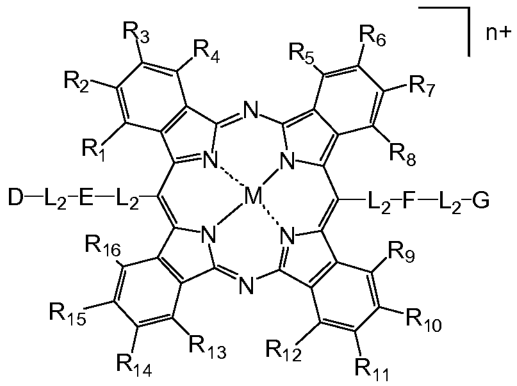

(V)

wherein

$R_1$-$R_{16}$ are each independently selected from H, alkyl and aryl; or two adjacent $R_1$-$R_{16}$ groups optionally form, together with the carbon atoms to which they are attached, a ring selected from cycloalkyl and aryl, and the remaining $R_1$-$R_{16}$ groups are each independently selected from H, alkyl and aryl;
D and G are each independently selected from H, alkyl, aryl, heteroaryl, oligothienyl, dialkyl amino, diaryl amino, triaryl amino, dialkylaryl amino, alkenyl, and combinations thereof;
E and F are each independently selected from arylene, heteroarylene, alkendiyl, alkyndiyl, and combinations thereof;
$L_2$ are each independently selected from a single bond, $-(C{\equiv}C)_p-$ and $-(CR{=}CR)_q-$, wherein R is H or - CN and wherein p and q are integers independently equal to 1, 2 or 3;
M represents 2 hydrogen atoms; or M is selected from Zn, Mg, Al, Si, Cu, Ru, Au, Sn, Pd, Pt, Ir and Ni; or M is selected from $Sn(IV)(L)_2$, $P(V)(L)_2$, Au(III), Ru(II)LL', Ir(III) wherein L and L' represent axial ligands selected from halogeno, hydroxo, alkoxide, carboxylato, CO and pyridine; and
n is 0 or 1.

**9.** Compound according to claim 8, wherein
$R_1$-$R_{16}$ are each independently selected from H, $C_1$-$C_6$-alkyl and $C_6$-aryl;
D and G are each independently selected from H, $C_1$-$C_6$-alkyl, $C_6$-aryl, di-$C_1$-$C_6$-alkyl amino, di-$C_6$-aryl amino, tri-$C_6$-aryl amino and di-$C_1$-$C_6$-alkyl-$C_6$-aryl amino, thienyl, oligothienyl, and combinations thereof; in particular phenyl, diphenyl amino and triphenylamino; wherein said groups may optionally be substituted by one or two substituents selected from alkyl, alkoxy, phenoxy, dialkylamino, diphenylamino, thioether, carboxylic group and sulfonic group;
E and F are each independently selected from $C_6$-arylene, 5- to 20-membered heteroarylene, -C=C-, -CH=CH-, and combinations thereof; in particular phenylene, thiendiyl, benzothiadiazoldiyl, benzotriazoldiyl, pyridindiyl, triazoldiyl, -C=C-, -CH=CH-, and combinations thereof;
$L_2$ are each independently selected from a single bond, -C=C- and -CR=CR-, wherein R is H or -CN; M represents 2 hydrogen atoms; or M is selected from $Sn(IV)(L)_2$, $P(V)(L)_2$, Au(III), Ru(II)LL', Ir(III) wherein L and L' represent axial ligands selected from halogeno, for example $Cl^-$, $Br^-$ or $I^-$; hydroxo ($OH^-$); alkoxide, for example $R'O^-$ wherein R' is alkyl or phenyl; carboxylato, for example $R'COO^-$wherein R' is alkyl or phenyl; CO; and pyridine; in particular $Sn(IV)(L)_2$, $P(V)(L)_2$, Au(III);
n is 0 or 1.

**10.** Compound according to claim 9, wherein said compound is

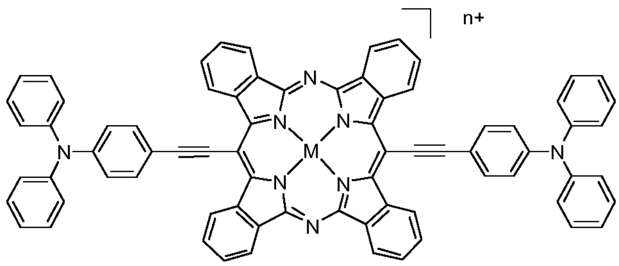

wherein M is $Sn(IV)(L)_2$ and n is 0, or M is $P(V)(L)_2$ and n is 0, or M is Au(III) and n is 1, or M is Ru(II)LL' and n is 0, or M is Ir(III) and n is 1;
wherein L is selected from $Cl^-$, $Br^-$, $I^-$, $OH^-$, $R'O^-$ and $R'COO^-$ with R' is alkyl or phenyl; and
wherein L' is selected from CO and pyridine.

**11.** Compound according to claim 8, wherein
$R_1$-$R_{16}$ are each independently selected from H, $C_1$-$C_6$-alkyl and $C_6$-aryl;
D and G are each independently selected from H, $C_6$-aryl, 5- to 20-membered heteroaryl, alkenyl, and combinations thereof; in particular phenyl, thienyl optionally fused with an *N*-alkyl pyrrolidine-2,5-dione, benzothiadiazolyl optionally fused with a 2-alkyl triazole, benzotriazolyl, pyridinyl, triazolyl, phthalimidyl, a pyridinium radical, a diketopyrrolopyrrole radical, an isoindigo radical, a *N*-alkyl-2,2'-bithiophene-3,3'-dicarboximide radical, dicyanovinyl, tricyanovinyl, and combinations thereof;
E and F are each independently selected from $C_6$-arylene, 5- to 20-membered heteroarylene, -C=C-, -CH=CH-, and combinations thereof; in particular phenylene, thiendiyl, benzothiadiazoldiyl, benzotriazoldiyl, pyridindiyl, triazoldiyl, -C=C-, -CH=CH-, and combinations thereof;
$L_2$ are each independently selected from a single bond, -C=C- and -CR=CR-, wherein R is H or -CN;
M represents 2 hydrogen atoms; or M is selected from Zn, Mg, Al, Si, Cu, Ru and Ni; in particular Zn, Mg and Cu; preferably Zn; and
n is 0.

**12.** Compound according to claim 11, wherein said compound is:

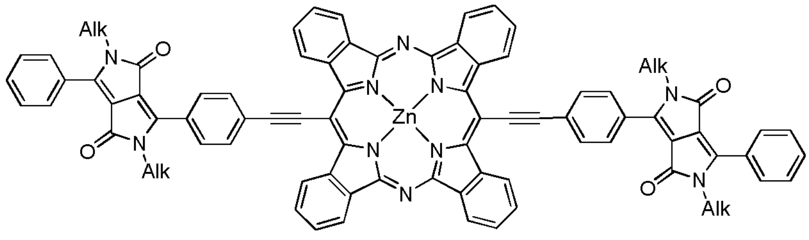

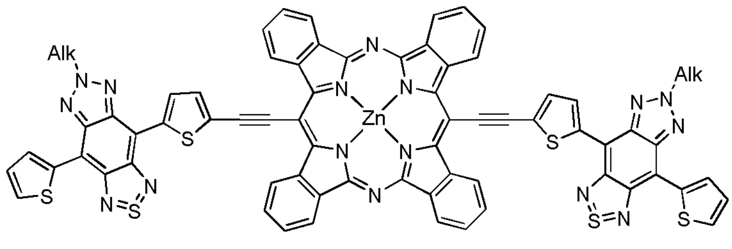

.

**13.** Organic solar cell comprising an anode, a cathode and a sensitizer, wherein the sensitizer is a compound as defined in any one of claims 8 to 12.

**14.** Organic solar cell according to claim 13, wherein the anode comprises a material selected from indium tin oxide and graphene and wherein the cathode comprises a metal selected from Al, Ag, Cu, or Au.

**15.** Use of a compound as defined in any one of claims 8 to 12 as a sensitizer for an organic solar cell.

## Patentansprüche

**1.** Verbindung der allgemeinen Formel (I):

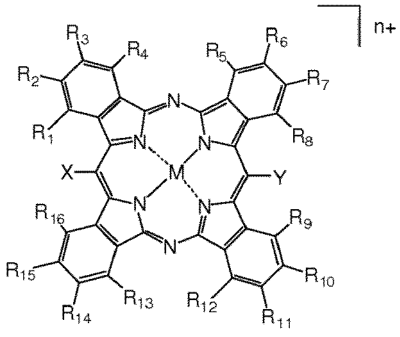

(I)

wobei

$R_1$-$R_{16}$ jeweils unabhängig voneinander ausgewählt sind aus H, Alkyl und Aryl; oder zwei benachbarte $R_1$-$R_{16}$ Gruppen gegebenenfalls zusammen mit den Kohlenstoffatomen, an die sie gebunden sind, einen Ring, ausgewählt aus Cycloalkyl und Aryl, bilden, und die übrigen $R_1$-$R_{16}$ Gruppen jeweils unabhängig voneinander ausgewählt sind aus H, Alkyl und Aryl;
X und Y, die ähnlich oder verschieden sind, jeweils wenigstens eine Gruppe ausgewählt aus H, Alkyl, Aryl, Arylen, Heteroaryl, Heteroarylen, Alkendiyl, Alkindiyl, Dialkylamino, Diarylamino, Triarylamino und Dialkylarylamino umfassen;
M für 2 Wasserstoffatome steht; oder M ausgewählt ist aus Zn, Mg, Al, Si, Cu, Ru, Au, Sn, Pd, Pt, Ir und Ni; oder M ist ausgewählt aus Sn(IV)$(L)_2$, P(V)$(L)_2$, Au(III), Ru(II)LL', Ir (III), wobei L und L' axiale Liganden, ausgewählt aus Halogeno, Hydroxo, Alkoxid, Carboxylato, CO und Pyridin, darstellen; und
n 0 oder 1 ist;
mit der Maßgabe, dass X und Y nicht beide H oder beide Alkyl oder beide Aryl sind.

**2.** Verbindung nach Anspruch 1, wobei die Verbindung der allgemeinen Formel (II) entspricht:

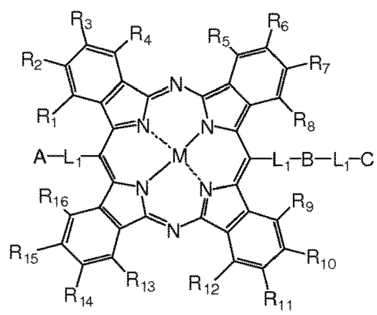

(II)

wobei

$R_1$-$R_{16}$ jeweils unabhängig voneinander ausgewählt sind aus H, Alkyl und Aryl; oder zwei benachbarte $R_1$-$R_{16}$ Gruppen gegebenenfalls zusammen mit den Kohlenstoffatomen, an die sie gebunden sind, einen Ring ausgewählt aus Cycloalkyl und Aryl bilden, und die übrigen $R_1$-$R_{16}$ Gruppen jeweils unabhängig voneinander ausgewählt sind aus H, Alkyl und Aryl;
A ausgewählt ist aus H, Alkyl, Aryl, Dialkylamino, Diarylamino, Triarylamino, Dialkylarylamino, Thienyl, Oligothienyl, und Kombinationen davon;
B ausgewählt ist aus Arylen, Heteroarylen, Alkendiyl, Alkindiyl und Kombinationen davon; C ausgewählt ist aus $-COOR_a$, $-COO^-$, $-PO_3H_2$, $-PO(OH)R_b$, $-CH=C(COOH)_2$, - CH=C(CN)(COOH), $-Si(OR_b)_3$ und

-C(O)-$CH_2$-C(O)-$CH_3$, wobei $R_a$ H, Alkyl, Amino, Dialkylamino, Diarylamino oder-C(O)-$R_b$ ist und wobei $R_b$ Alkyl ist;

$L_1$ jeweils unabhängig voneinander ausgewählt sind aus einer Einfachbindung, $-(C{\equiv}C)_m-$ und $-(CH{=}CH)_o-$, wobei m und o unabhängig voneinander ganze Zahlen gleich 1, 2 oder 3 sind;

M 2 Wasserstoffatome darstellt; oder M ausgewählt ist aus Zn, Mg, Al, Si, Cu, Ru, Au, Sn, Pd, Pt, Ir und Ni.

**3.** Verbindung nach Anspruch 2, wobei
$R_1$-$R_{16}$ jeweils unabhängig voneinander ausgewählt sind aus H, $C_1$-$C_6$-Alkyl und $C_6$-Aryl;
A ausgewählt ist aus H, $C_1$-$C_6$-Alkyl, $C_6$-Aryl, di-$C_1$-$C_6$-Alkylamino, di-$C_6$-Arylamino, tri-$C_6$-Arylamino, di-$C_1$-$C_6$-Alkyl-$C_6$-arylamino, Thienyl, Oligothienyl, und Kombinationen davon; B ausgewählt ist aus $C_6$-Arylen, 5- bis 10-gliedrigem Heteroarylen, -C=C-, -CH=CH- und Kombinationen davon;
B insbesondere ausgewählt ist aus Phenylen, Thiendiyl, Benzothiadiazoldiyl, Benzotriazoldiyl, Pyridindiyl, Triazoldiyl, -C=C-, -CH=CH-, und Kombinationen davon;
C ausgewählt ist aus -COOH, -$PO_3H_2$, -CH=C(CN)(COOH), -$Si(OMe)_3$, -$Si(OEt)_3$ und - C(O)-$CH_2$-C(O)-$CH_3$;
$L_1$ jeweils unabhängig voneinander ausgewählt sind aus einer Einfachbindung, -C=C- und -CH=CH-;
M 2 Wasserstoffatome darstellt; oder M ausgewählt ist aus Zn, Mg, Al, Si, Cu, Ru und Ni; insbesondere Zn, Mg und Cu; vorzugsweise Zn.

**4.** Verbindung nach Anspruch 2 oder 3, wobei die Verbindung der allgemeinen Formel (III) oder (IV) entspricht:

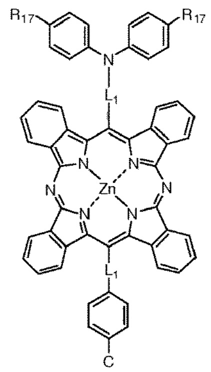

(III)

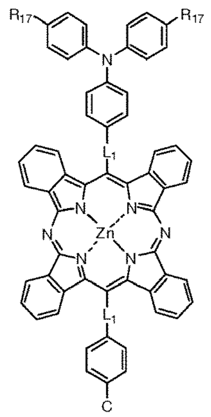

(IV)

wobei

$R_{17}$ unabhängig ausgewählt ist aus H, Alkoxy und Phenyl, substituiert durch eine oder zwei Alkoxygruppen;
$L_1$ unabhängig ausgewählt ist aus einer Bindung und -C=C-; und
C unabhängig ausgewählt ist aus -COOH und -CH=C(CN)(COOH).

**5.** Verbindung nach einem der Ansprüche 2 bis 4, wobei die Verbindung aus den folgenden Verbindungen ausgewählt ist:

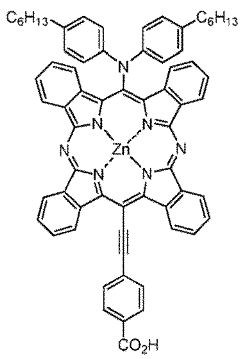

,

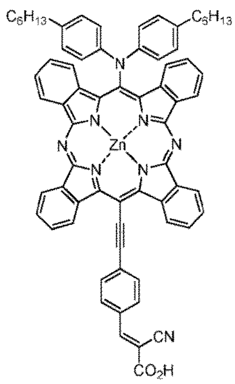

,

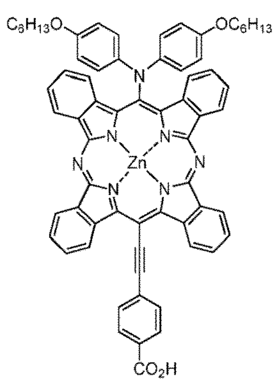

,

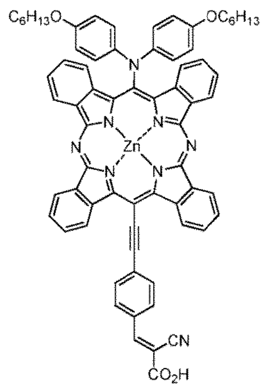

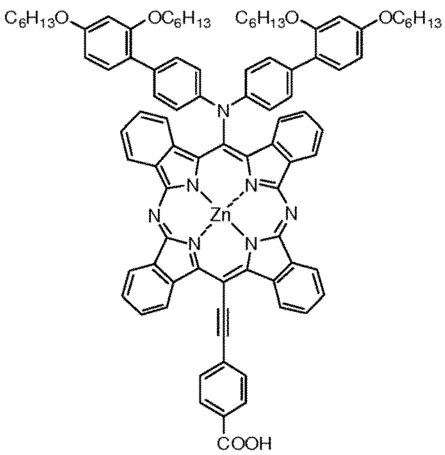
,
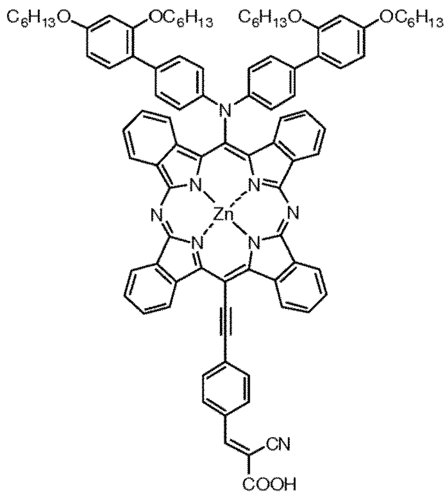
,

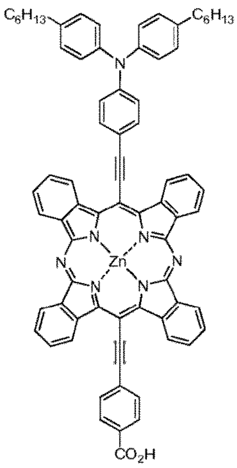
,
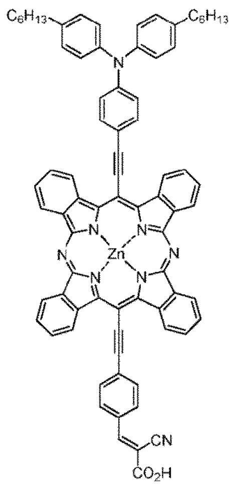
,
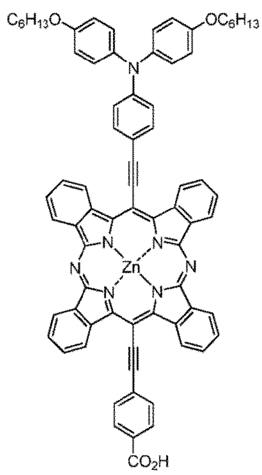
,
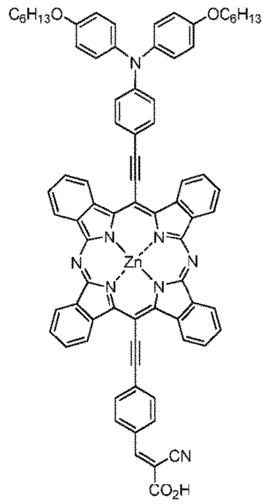
,

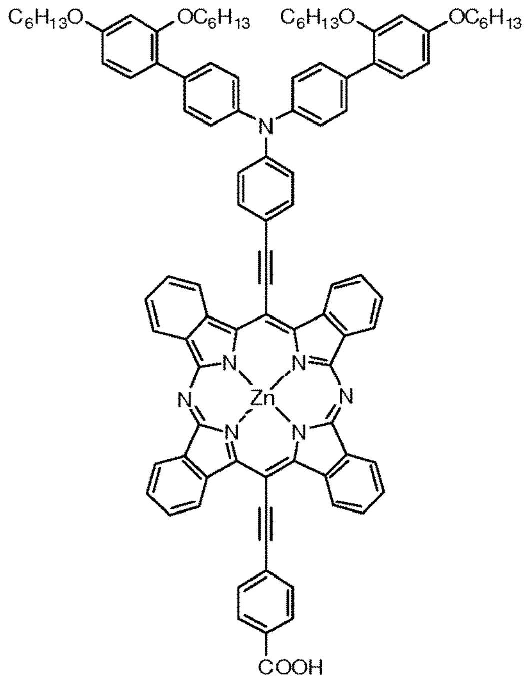

,

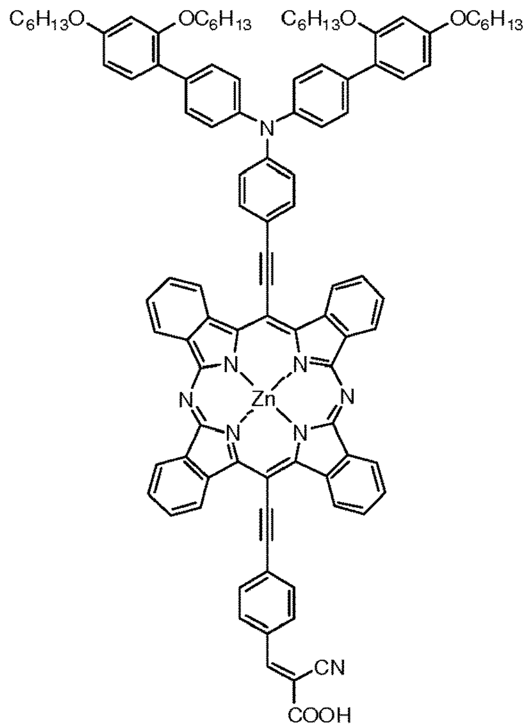

,

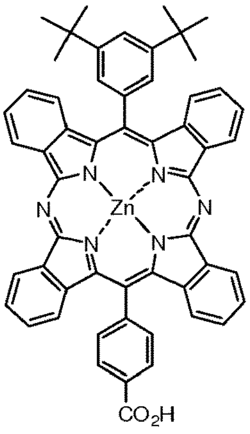

**CROSSDAP** ,

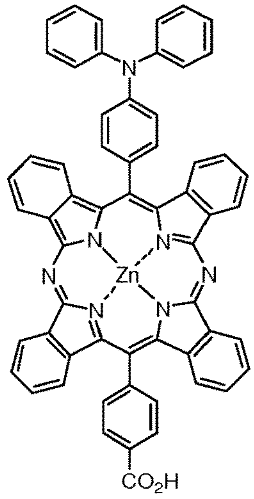

**TPA-CROSSDAP**.

6. Farbstoffsolarzelle, umfassend eine Anode, eine Gegenelektrode, einen nanokristallinen Halbleiter, einen Sensibilisator und ein Elektrolyt, wobei derSensibilisator eine Verbindung wie in einem der Ansprüche 2 bis 5 definiert umfasst.

7. Verwendung einer Verbindung nach einem der Ansprüche 2 bis 5 als einen Sensibilisator für eine Farbstoffsolarzelle.

8. Verbindung nach Anspruch 1, wobei die Verbindung der allgemeinen Formel (V) entspricht:

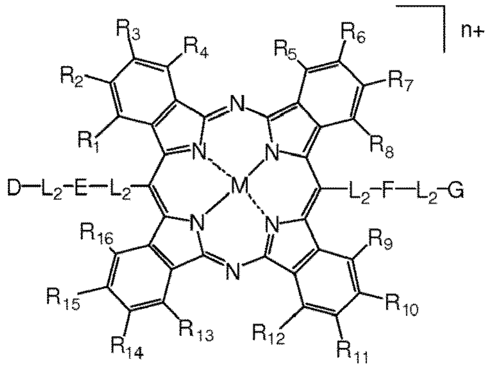

(V)

wobei

$R_1$-$R_{16}$ jeweils unabhängig voneinander ausgewählt sind aus H, Alkyl und Aryl; oder zwei benachbarte $R_1$-$R_{16}$ Gruppen gegebenenfalls zusammen mit den Kohlenstoffatomen, an die sie gebunden sind, einen Ring ausgewählt aus Cycloalkyl und Aryl bilden und die übrigen $R_1$-$R_{16}$ Gruppen jeweils unabhängig voneinander ausgewählt sind aus H, Alkyl und Aryl;
D und G jeweils unabhängig voneinander ausgewählt sind aus H, Alkyl, Aryl, Heteroaryl, Oligothienyl, Dialkylamino, Diarylamino, Triarylamino, Dialkylarylamino, Alkenyl und Kombinationen davon;
E und F jeweils unabhängig voneinander ausgewählt sind aus Arylen, Heteroarylen, Alkendiyl, Alkindiyl und Kombinationen davon;
$L_2$ jeweils unabhängig voneinander ausgewählt sind aus einer Einfachbindung, $-(C\equiv C)_p-$ und $-(CR=CR)_q-$, wobei R H oder -CN ist und wobei p und q unabhängig voneinander ganze Zahlen gleich 1, 2 oder 3 sind;
M 2 Wasserstoffatome darstellt; oder M ausgewählt ist aus Zn, Mg, Al, Si, Cu, Ru, Au, Sn, Pd, Pt, Ir und Ni; oder M ausgewählt ist aus $Sn(IV)(L)_2$, $P(V)(L)_2$, Au(III), Ru(II)LL'; Ir(III), wobei L und L' axiale Liganden darstellen, ausgewählt aus Halogeno, Hydroxo, Alkoxid, Carboxylat, CO und Pyridin; und
n 0 oder 1 ist.

**9.** Verbindung nach Anspruch 8, wobei
$R_1$-$R_{16}$ jeweils unabhängig voneinander ausgewählt sind aus H, $C_1$-$C_6$-Alkyl und $C_6$-Aryl; D und G jeweils unabhängig voneinander ausgewählt sind aus H, $C_1$-$C_6$-Alkyl, $C_6$-Aryl, di-$C_1$-$C_6$-Alkylamino, di-$C_6$-Arylamino, tri-$C_6$-Arylamino und di-$C_1$-$C_6$-Alkyl-$C_6$-Arylamino, Thienyl, Oligothienyl und Kombinationen davon; insbesondere Phenyl, Diphenylamino und Triphenylamino; wobei die Gruppen gegebenenfalls mit ein oder zwei Substituenten ausgewählt aus Alkyl, Alkoxy, Phenoxy, Dialkylamino, Diphenylamino, Thioether, Carboxylgruppe und Sulfongruppe, substituiert sein können;
E und F jeweils unabhängig voneinander ausgewählt sind aus $C_6$-Arylen, 5- bis 20-gliedrigem Heteroarylen, -C=C-, -CH=CH-, und Kombinationen davon; insbesondere Phenylen, Thiendiyl, Benzothiadiazoldiyl, Benzotriazoldiyl, Pyridindiyl, Triazoldiyl, -C=C-, -CH=CH-, und Kombinationen davon;
$L_2$ jeweils unabhängig voneinander ausgewählt sind aus einer Einfachbindung, -C=C- und -CR=CR-, wobei R H oder -CN ist;
M 2 Wasserstoffatome darstellt; oder M ausgewählt ist aus $Sn(IV)(L)_2$, $P(V)(L)_2$, Au(III), Ru(II)LL'; Ir (III), wobei L und L' axiale Liganden darstellen, ausgewählt aus Halogeno, zum Beispiel $Cl^-$, $Br^-$ oder $I^-$; Hydroxo ($OH^-$); Alkoxid, zum Beispiel $R'O^-$, wobei R' Alkyl oder Phenyl ist; Carboxylato, zum Beispiel $R'COO^-$, wobei R' Alkyl oder Phenyl ist; CO; und Pyridin; insbesondere Sn $(IV)(L)_2$, $P(V)(L)_2$, Au(III);
n 0 oder 1 ist.

**10.** Verbindung nach Anspruch 9, wobei die Verbindung

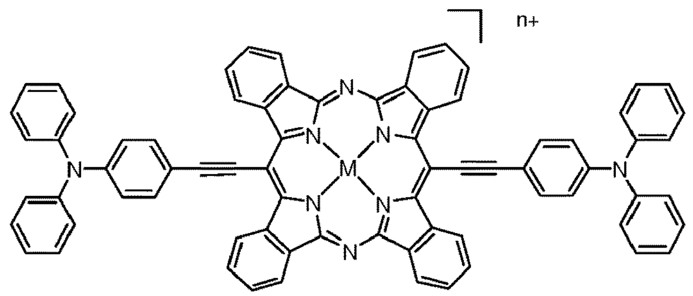

ist, wobei M $Sn(IV)(L)_2$ ist und n 0 ist, oder M $P(V)(L)_2$ ist und n 0 ist, oder M Au(III) ist und n 1 ist, oder M Ru(II)LL' ist und n 0 ist, oder M Ir(III) und n 1 ist;
wobei L ausgewählt ist aus $Cl^-$, $Br^-$, $I^-$, $OH^-$, $R'O^-$ und $R'COO^-$, wobei R' Alkyl oder Phenyl ist; und
wobei L' ausgewählt ist aus CO und Pyridin.

**11.** Verbindung nach Anspruch 8, wobei
$R_1$-$R_{16}$ jeweils unabhängig voneinander ausgewählt sind aus H, $C_1$-$C_6$-Alkyl und $C_6$-Aryl; D und G jeweils unabhängig voneinander ausgewählt sind aus H, $C_6$-Aryl, 5- bis 20-gliedrigem Heteroaryl, Alkenyl und Kombinationen davon; insbesondere Phenyl, Thienyl, gegebenenfalls fusioniert mit einem N-Alkyl-Pyrrolidin-2,5-dion, Benzothiadiazolyl, gegebenenfalls fusioniert mit einem 2-Alkyltriazol, Benzotriazolyl, Pyridinyl, Triazolyl, Phthalimidyl, einem Pyridinium-Rest, einem Diketopyrrolopyrrol-Rest, einem Isoindigo-Rest, einem N-Alkyl-2,2'-bithiophen-3,3'-dicarboximid-Rest, Dicyanovinyl, Tricyanovinyl und Kombinationen davon;
E und F jeweils unabhängig voneinander ausgewählt sind aus $C_6$-Arylen, 5- bis 20-gliedrigem Heteroarylen, -C=C-, -CH=CH-, und Kombinationen davon; insbesondere Phenylen, Thiendiyl, Benzothiadiazoldiyl, Benzotriazoldiyl, Pyridindiyl, Triazoldiyl, -C=C-, -CH=CH-, und Kombinationen davon;
$L_2$ jeweils unabhängig voneinander ausgewählt sind aus einer Einfachbindung, -C=C- und -CR=CR-, wobei R H oder -CN ist;
M 2 Wasserstoffatome darstellt; oder M ausgewählt ist aus Zn, Mg, Al, Si, Cu, Ru und Ni; insbesondere Zn, Mg und Cu; vorzugsweise Zn; und
n 0 ist.

**12.** Verbindung nach Anspruch 11, wobei die Verbindung

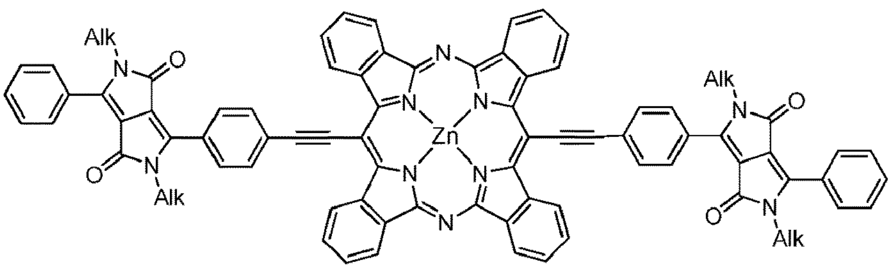

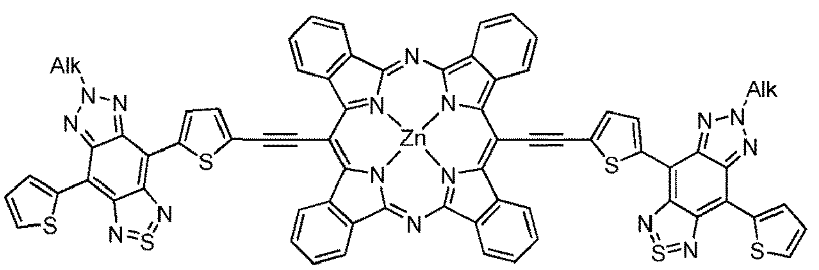

ist.

**13.** Organische Solarzelle, umfassend eine Anode, eine Kathode und einen Sensibilisator, wobei der Sensibilisator eine Verbindung ist, wie in einem der Ansprüche 8 bis 12 definiert.

**14.** Organische Solarzelle nach Anspruch 13, wobei die Anode ein Material ausgewählt aus Indiumzinnoxid und Graphen umfasst und wobei die Kathode ein Metall ausgewählt aus Al, Ag, Cu oder Au umfasst.

**15.** Verwendung einer Verbindung, wie in einem der Ansprüche 8 bis 12 definiert, als einen Sensibilisator für eine organische Solarzelle.

**Revendications**

**1.** Composé de formule générale (I) :

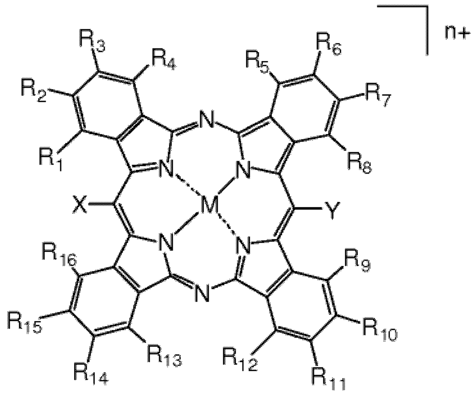

(I)

dans lequel

$R_1$ à $R_{16}$ sont chacun indépendamment sélectionnés parmi H, alkyle et aryle ; ou deux groupes $R_1$ à $R_{16}$ adjacents forment facultativement, conjointement avec les atomes de carbone auxquels ils sont attachés, un cycle sélectionné parmi cycloalkyle et aryle, et les groupes $R_1$ à $R_{16}$ restants sont chacun indépendamment sélectionnés parmi H, alkyle et aryle ;
X et Y, identiques ou différents, comprennent chacun au moins un groupe sélectionné parmi H, alkyle, aryle, arylène, hétéroaryle, hétéroarylène, alcèndiyle, alcyndiyle, dialkylamino, diarylamino, triarylamino et dialkylarylamino ;
M représente 2 atomes d'hydrogène ; ou M est sélectionné parmi Zn, Mg, Al, Si, Cu, Ru, Au, Sn, Pd, Pt, Ir et Ni ; ou M est sélectionné parmi $Sn(IV)(L)_2$, $P(V)(L)_2$, Au(III), Ru(II)LL', Ir(III) dans lequel L et L' représentent des ligands axiaux sélectionnés parmi halogéno, hydroxo, alcoxyde, carboxylo, CO et pyridine ; et
n vaut 0 ou 1 ;
à condition que X et Y ne soient pas tous les deux H, ou tous les deux alkyle ou tous les deux aryle.

**2.** Composé selon la revendication 1, dans lequel ledit composé correspond à la formule générale (II) :

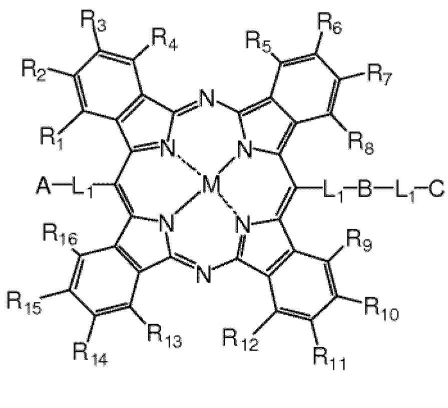

(II)

dans lequel

$R_1$ à $R_{16}$ sont chacun indépendamment sélectionnés parmi H, alkyle et aryle ; ou deux groupes $R_1$ à $R_{16}$ adjacents forment facultativement, conjointement avec les atomes de carbone auxquels ils sont attachés, un cycle sélectionné parmi cycloalkyle et aryle, et les groupes $R_1$ à $R_{16}$ restants sont chacun indépendamment sélectionnés parmi H, alkyle et aryle ;
A est sélectionné parmi H, alkyle, aryle, dialkylamino, diarylamino, triarylamino, dialkylarylamino, thiényle, oligothiényle, et des combinaisons de ceux-ci ;
B est sélectionné parmi arylène, hétéroarylène, alcèndiyle, alcyndiyle et des combinaisons de ceux-ci ;
C est sélectionné parmi $-COOR_a$, $-COO^-$, $-PO_3H_2$, $-PO(OH)R_b$, $-CH=C(COOH)_2$, -CH=C(CN)(COOH), $-Si(OR_b)_3$ et $-C(O)-CH_2-C(O)-CH_3$ dans lequel $R_a$ est H, alkyle, amino, dialkylamino, diarylamino ou $-C(O)-R_b$ et dans lequel $R_b$ est alkyle ;
$L_1$ sont chacun indépendamment sélectionnés parmi une liaison simple, $-(C{\equiv}C)_m-$ et - $(CH=CH)_o-$, dans lequel m et o sont des entiers indépendamment égaux à 1, 2 ou 3 ;
M représente 2 atomes d'hydrogène ; ou M est sélectionné parmi Zn, Mg, Al, Si, Cu, Ru, Au, Sn, Pd, Pt, Ir et Ni.

**3.** Composé selon la revendication 2, dans lequel
$R_1$ à $R_{16}$ sont chacun indépendamment sélectionnés parmi H, $C_1$-$C_6$-alkyle et $C_6$-aryle ;
A est sélectionné parmi H, $C_1$-$C_6$-alkyle, $C_6$-aryle, di-$C_1$-$C_6$-alkylamino, di-$C_6$-arylamino, tri-$C_6$-arylamino, di-$C_1$-$C_6$-alkyl-$C_6$-arylamino, thiényle, oligothiényle, et des combinaisons de ceux-ci ;
B est sélectionné parmi $C_6$-arylène, hétéroarylène à 5 à 10 chaînons, $-C{\equiv}C-$, -CH=CH- et des combinaisons de ceux-ci ; en particulier B est sélectionné parmi phénylène, thièndiyle, benzothiadiazoldiyle, benzotriazoldiyle, pyridindiyle, triazoldiyle, -C≡-, -CH=CH-, et des combinaisons de ceux-ci ;
C est sélectionné parmi -COOH, $-PO_3H_2$, -CH=C(CN)(COOH), $-Si(OMe)_3$, $Si(OEt)_3$ et $-C(O)-CH_2-C(O)-CH_3$ ;
$L_1$ sont chacun indépendamment sélectionnés parmi une liaison simple, $-C{\equiv}C-$ et -CH=CH- ;
M représente 2 atomes d'hydrogène ; ou M est sélectionné parmi Zn, Mg, Al, Si, Cu, Ru et Ni ; en particulier Zn, Mg et Cu ; de préférence Zn.

**4.** Composé selon la revendication 2 ou 3, dans lequel ledit composé correspond à la formule générale (III) ou (IV) :

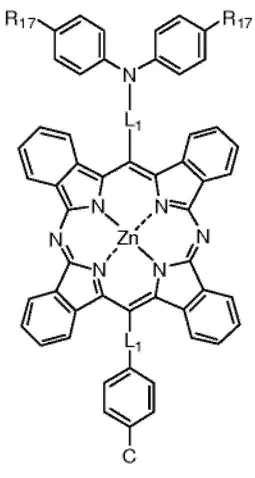

(III)

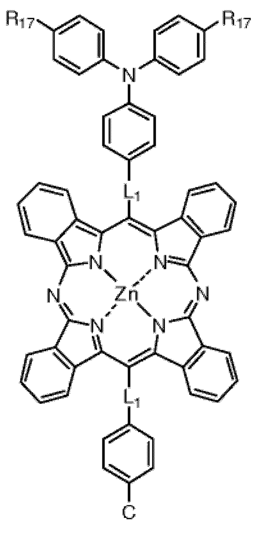

(IV)

dans lequel

$R_{17}$ est indépendamment sélectionné parmi H, alcoxy et phényle substitué par un ou deux groupes alcoxy ;
$L_1$ est indépendamment sélectionné parmi une liaison et $-C{\equiv}C-$, et
C est indépendamment sélectionné parmi -COOH et -CH=C(CN)(COOH).

**5.** Composé selon l'une quelconque des revendications 2 à 4, dans lequel ledit composé est sélectionné parmi les composés suivants :

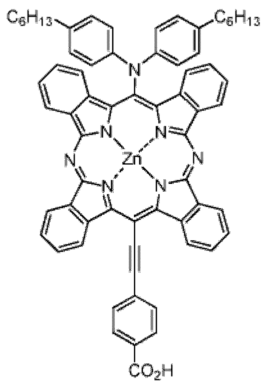 , 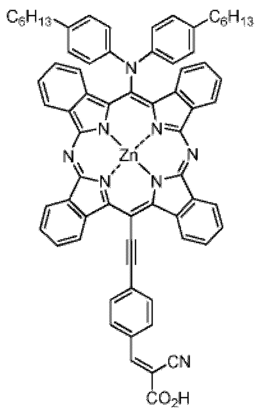 , 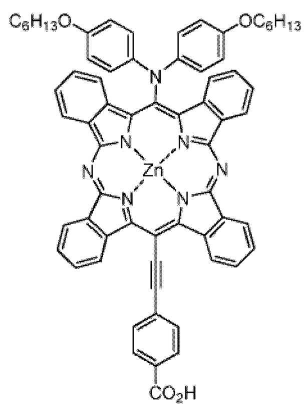 , 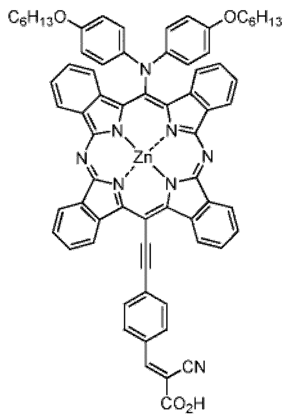

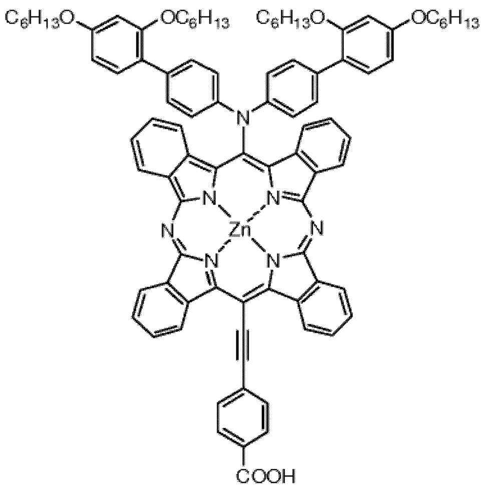 , 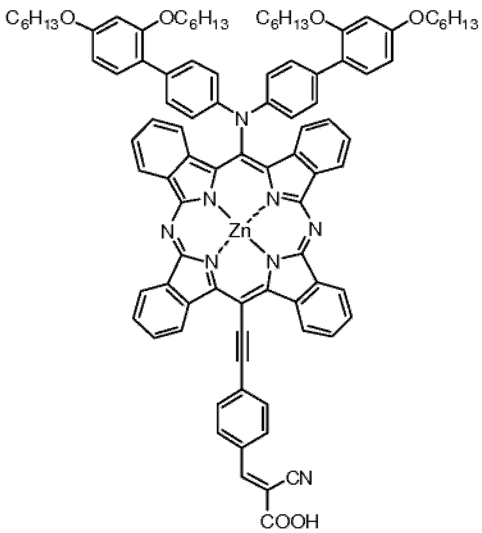 ,

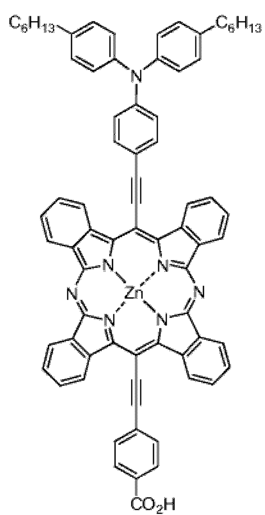 , 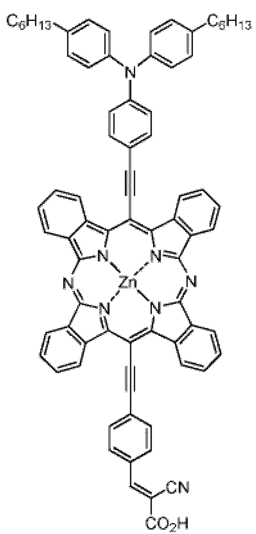 , 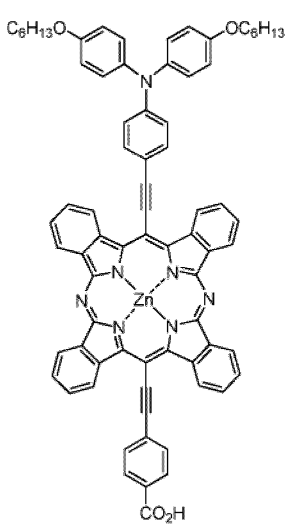 , 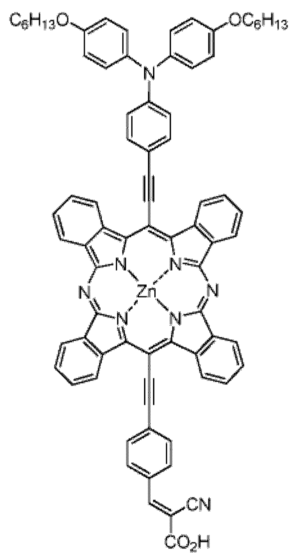 ,

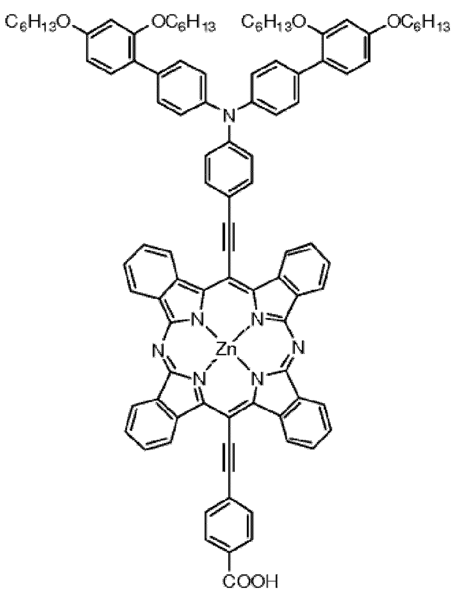

,

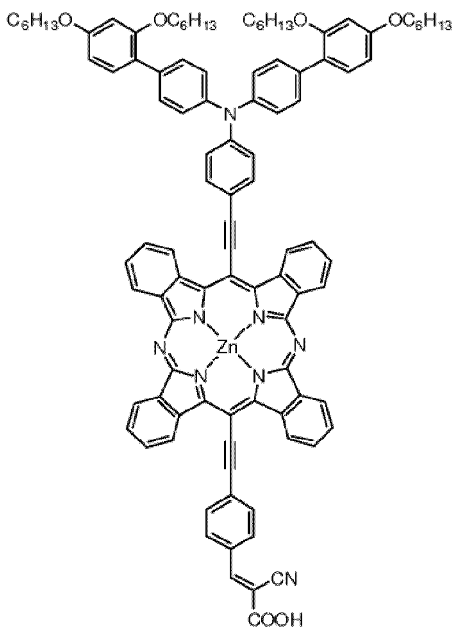

,

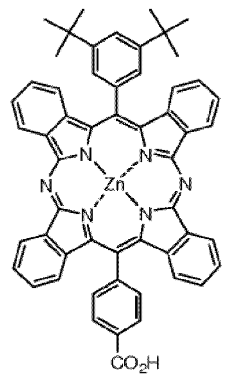

CROSSDAP ,

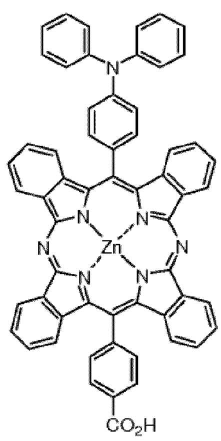

TPA-CROSSDAP.

6. Cellule solaire à colorant comprenant une anode, une contre-électrode, un semiconducteur nanocristallin, un sensibilisateur et un électrolyte, dans laquelle le sensibilisateur comprend un composé tel que défini dans l'une quelconque des revendications 2 à 5.

7. Utilisation d'un composé tel que défini dans l'une quelconque des revendications 2 à 5 en tant que sensibilisateur pour une cellule solaire à colorant.

8. Composé selon la revendication 1, dans lequel ledit composé correspond à la formule générale (V) :

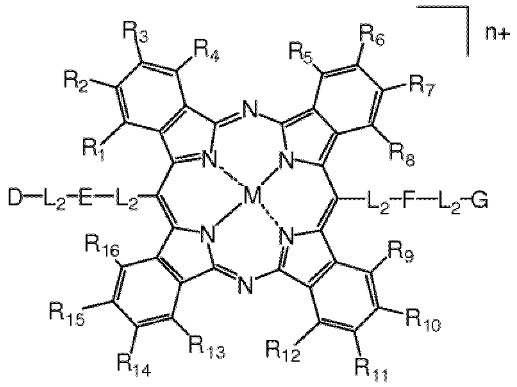

(V)

dans lequel

$R_1$ à $R_{16}$ sont chacun indépendamment sélectionnés parmi H, alkyle et aryle ; ou deux groupes $R_1$ à $R_{16}$ adjacents forment facultativement, conjointement avec les atomes de carbone auxquels ils sont attachés, un cycle sélectionné parmi cycloalkyle et aryle, et les groupes $R_1$ à $R_{16}$ restants sont chacun indépendamment sélectionnés parmi H, alkyle et aryle ;

D et G sont chacun indépendamment sélectionnés parmi H, alkyle, aryle, hétéroaryle, oligothiényle, dialkylamino, diarylamino, triarylamino, dialkylarylamino, alcényle, et des combinaisons de ceux-ci ;

E et F sont chacun indépendamment sélectionnés parmi arylène, hétéroarylène, alcèndiyle, alcyndiyle, et des combinaisons de ceux-ci ;

$L_2$ sont chacun indépendamment sélectionnés parmi une liaison simple, $-(C\equiv C)_p-$ et - $(CR=CR)_q-$, dans lequel R est H ou -CN et dans lequel p et q sont des entiers indépendamment égaux à 1, 2 ou 3 ;

M représente 2 atomes d'hydrogène ; ou M est sélectionné parmi Zn, Mg, Al, Si, Cu, Ru, Au, Sn, Pd, Pt, Ir et Ni ; ou M est sélectionné parmi $Sn(IV)(L)_2$, $P(V)(L)_2$, Au(III), Ru(II)LL', Ir(III) dans lequel L et L' représentent des ligands axiaux sélectionnés parmi halogéno, hydroxo, alcoxyde, carboxylo, CO et pyridine ; et

n vaut 0 ou 1.

**9.** Composé selon la revendication 8, dans lequel

$R_1$ à $R_{16}$ sont chacun indépendamment sélectionnés parmi H, $C_1$-$C_6$-alkyle et $C_6$-aryle ;

D et G sont chacun indépendamment sélectionnés parmi H, $C_1$-$C_6$-alkyle, $C_6$-aryle, di-$C_1$-$C_6$-alkylamino, di-$C_6$-arylamino, tri-$C_6$-arylamino et di-$C_1$-$C_6$-alkyl-$C_6$-arylamino, thiényle, oligothiényle, et des combinaisons de ceux-ci ; en particulier phényle, diphénylamino et triphénylamino ; dans lequel lesdits groupes peuvent être facultativement substitués par un ou deux substituants sélectionnés parmi alkyle, alcoxy, phénoxy, dialkylamino, diphénylamino, thioéther, un groupe carboxylique et un groupe sulfonique ;

E et F sont chacun indépendamment sélectionnés parmi $C_6$-arylène, hétéroarylène à 5 à 20 chaînons, -C≡C-, -CH=CH- et des combinaisons de ceux-ci ; en particulier phénylène, thièndiyle, benzothiadiazoldiyle, benzotriazoldiyle, pyridindiyle, triazoldiyle, -C≡C-, -CH=CH-, et des combinaisons de ceux-ci ;

$L_2$ sont chacun indépendamment sélectionnés parmi une liaison simple, -(C=C)- et - CR=CR-, dans lequel R est H ou -CN ;

M représente 2 atomes d'hydrogène ; ou M est sélectionné parmi $Sn(IV)(L)_2$, $P(V)(L)_2$, Au(III), Ru(II)LL', Ir(III) dans lequel L et L' représentent des ligands axiaux sélectionnés parmi halogéno, par exemple $Cl^-$, $Br^-$ ou $I^-$ ; hydroxo ($OH^-$) ; alcoxyde, par exemple $R'O^-$ dans lequel R' est alkyle ou phényle ; carboxylo, par exemple $R'COO^-$dans lequel R' est alkyle ou phényle ; CO ; et pyridine ; en particulier $Sn(IV)(L)_2$, $P(V)(L)_2$, Au(III) ;

n vaut 0 ou 1.

**10.** Composé selon la revendication 9, dans lequel ledit composé est

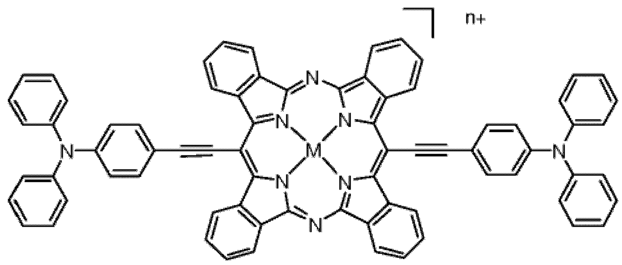

dans lequel M est Sn(IV)$(L)_2$ et n vaut 0, ou M est P(V)$(L)_2$ et n vaut 0, ou M est Au(III) et n vaut 1, ou M est Ru(II)LL' et n vaut 0, ou M est Ir(III) et n vaut 1,
dans lequel L est sélectionné parmi $Cl^-$, $Br^-$, $I^-$, $CH^-$, $R'O^-$ et $R'COO^-$, R' étant alkyle ou phényle ; et
dans lequel L' est sélectionné parmi CO et pyridine.

**11.** Composé selon la revendication 8, dans lequel
$R_1$ à $R_{16}$ sont chacun indépendamment sélectionnés parmi H, $C_1$-$C_6$-alkyle et $C_6$-aryle ; D et G sont chacun indépendamment sélectionnés parmi H, $C_6$-aryle, hétéroaryle à 5 à 20 chaînons, alcényle, et des combinaisons de ceux-ci ; en particulier phényle, thiényle facultativement fusionné avec une *N*-alkylpyrolidine-2,5-dione, benzothiadiazolyle facultativement fusionné avec un 2-alkyltriazole, benzotriazolyle, pyridinyle, triazolyle, phtalimidyle, un radical pyridinium, un radical dicétopyrrolopyrrole, un radical isoindigo, un radical *N*-alkyl-2,2'-bithiophène-3,3'-dicarboximide, dicyanovinyle, tricyanovinyle, et des combinaisons de ceux-ci ;
E et F sont chacun indépendamment sélectionnés parmi $C_6$-arylène, hétéroarylène à 5 à 20 chaînons, -C≡C-, -CH=CH- et des combinaisons de ceux-ci ; en particulier phénylène, thièndiyle, benzothiadiazoldiyle, benzotriazoldiyle, pyridindiyle, triazoldiyle, -C≡C-, -CH=CH-, et des combinaisons de ceux-ci ;
$L_2$ sont chacun indépendamment sélectionnés parmi une liaison simple, -(C=C)- et - CR=CR-, dans lequel R est H ou -CN ;
M représente 2 atomes d'hydrogène ; ou M est sélectionné parmi Zn, Mg, Al, Si, Cu, Ru et Ni ; en particulier Zn, Mg et Cu ; de préférence Zn ; et
n vaut 0.

**12.** Composé selon la revendication 11, dans lequel le composé est :

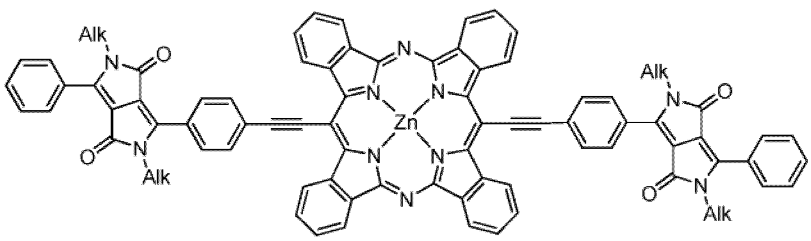

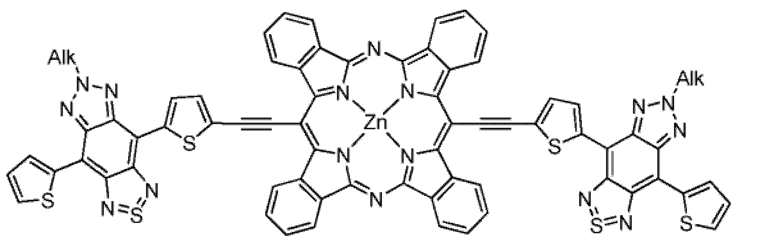

**13.** Cellule solaire organique comprenant une anode, une cathode et un sensibilisateur, dans lequel le sensibilisateur est un composé tel que défini dans l'une quelconque des revendications 8 à 12.

**14.** Cellule solaire organique selon la revendication 13, dans laquelle l'anode comprend un matériau sélectionné parmi l'oxyde d'indium-étain et le graphène et dans laquelle la cathode comprend un métal sélectionné parmi Al, Ag, Cu ou Au.

15. Utilisation d'un composé tel que défini dans l'une quelconque des revendications 8 à 12, en tant que sensibilisateur pour une cellule solaire organique.

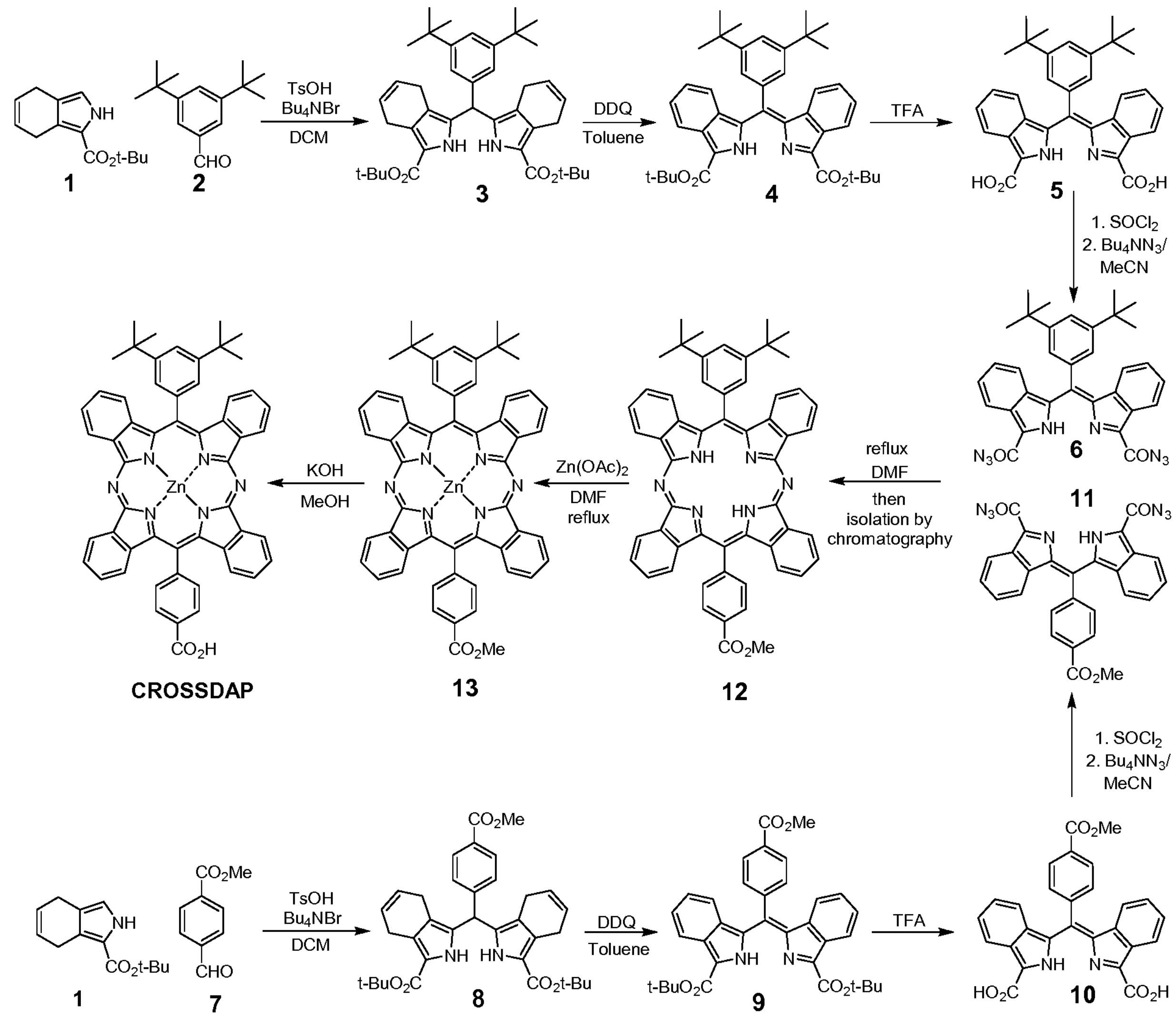
1
2
TsOH
$Bu_4NBr$
DCM
3
DDQ
Toluene
4
TFA
5
1. $SOCl_2$
2. $Bu_4NN_3$/
MeCN
6
11
reflux
DMF
then
isolation by
chromatography
12
$Zn(OAc)_2$
DMF
reflux
13
KOH
MeOH
CROSSDAP
1
7
TsOH
$Bu_4NBr$
DCM
8
DDQ
Toluene
9
TFA
10
1. $SOCl_2$
2. $Bu_4NN_3$/
MeCN

**Figure 1**

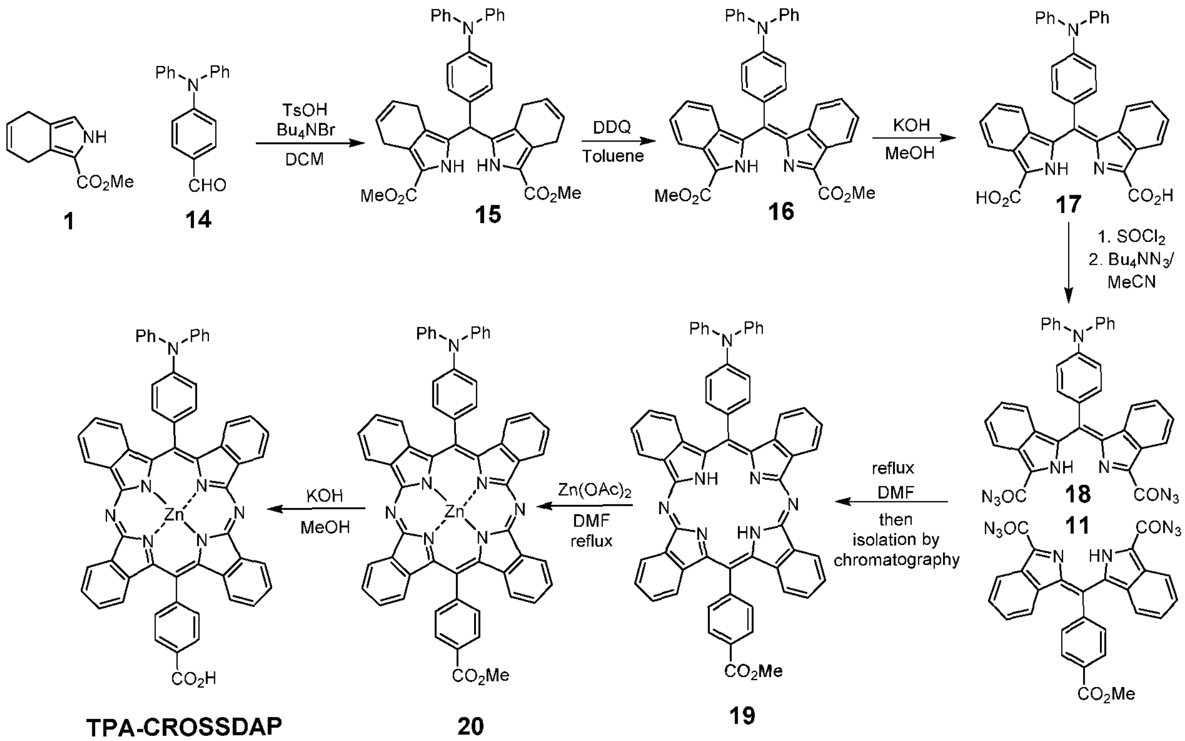


1 14 15 16 17 18 11 19 20 TPA-CROSSDAP

Figure 2

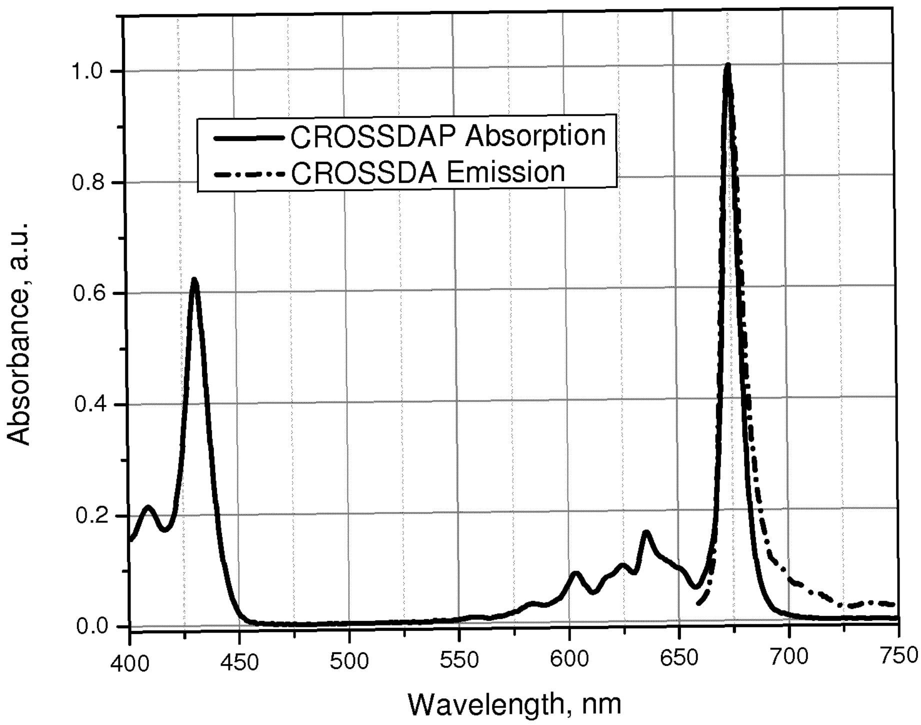


Figure 3

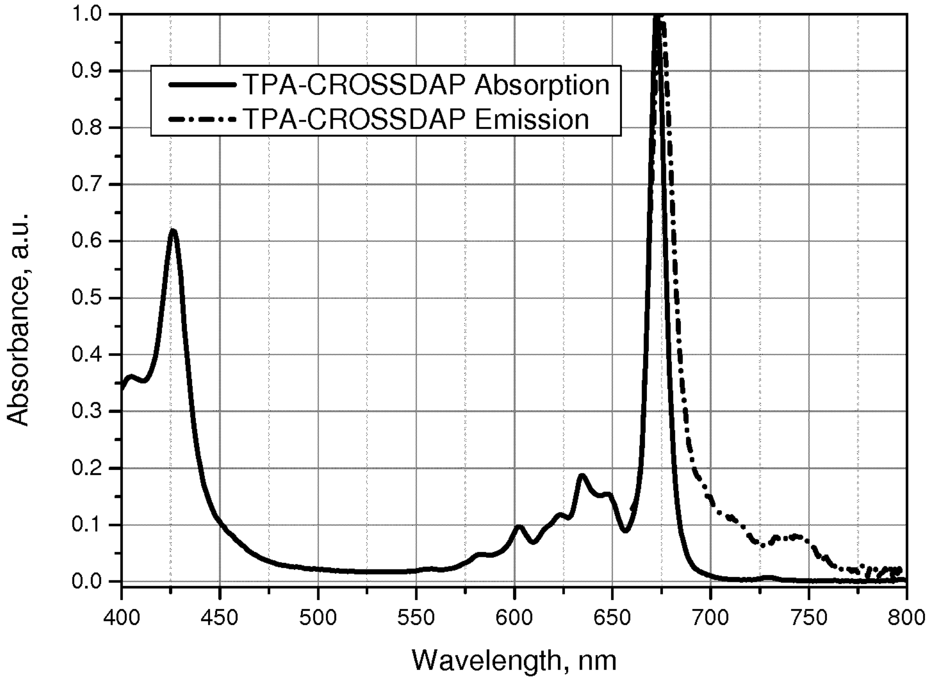


**Figure 4**

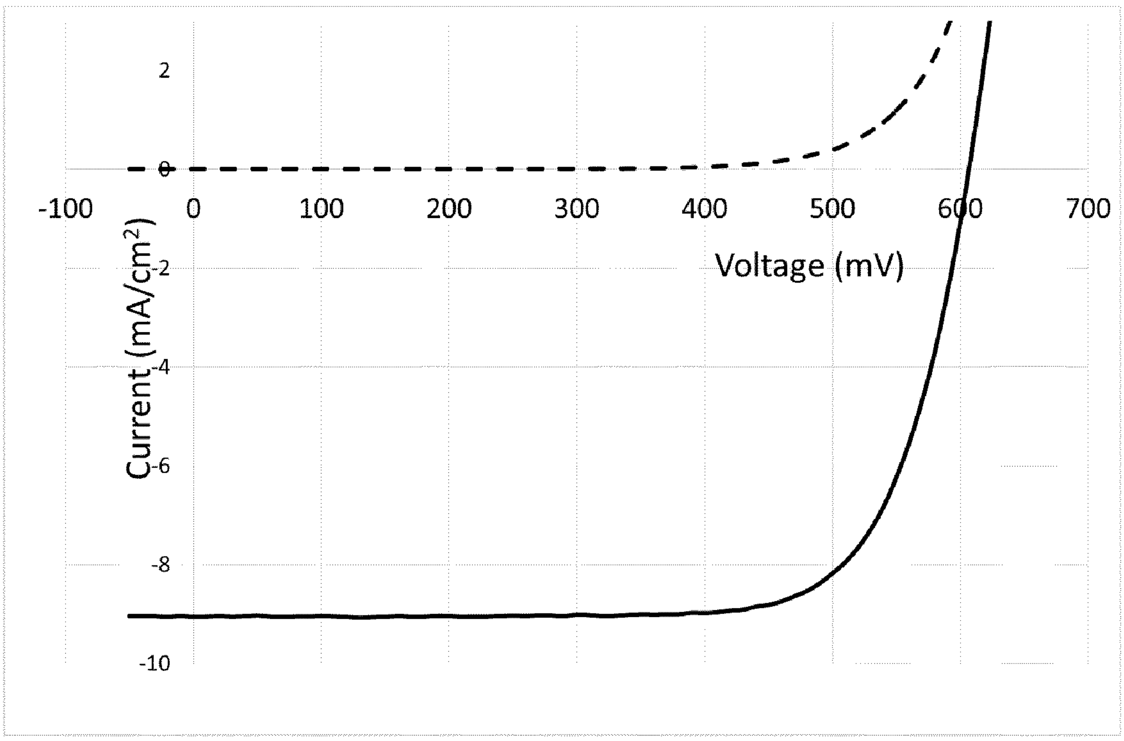


**Figure 5**

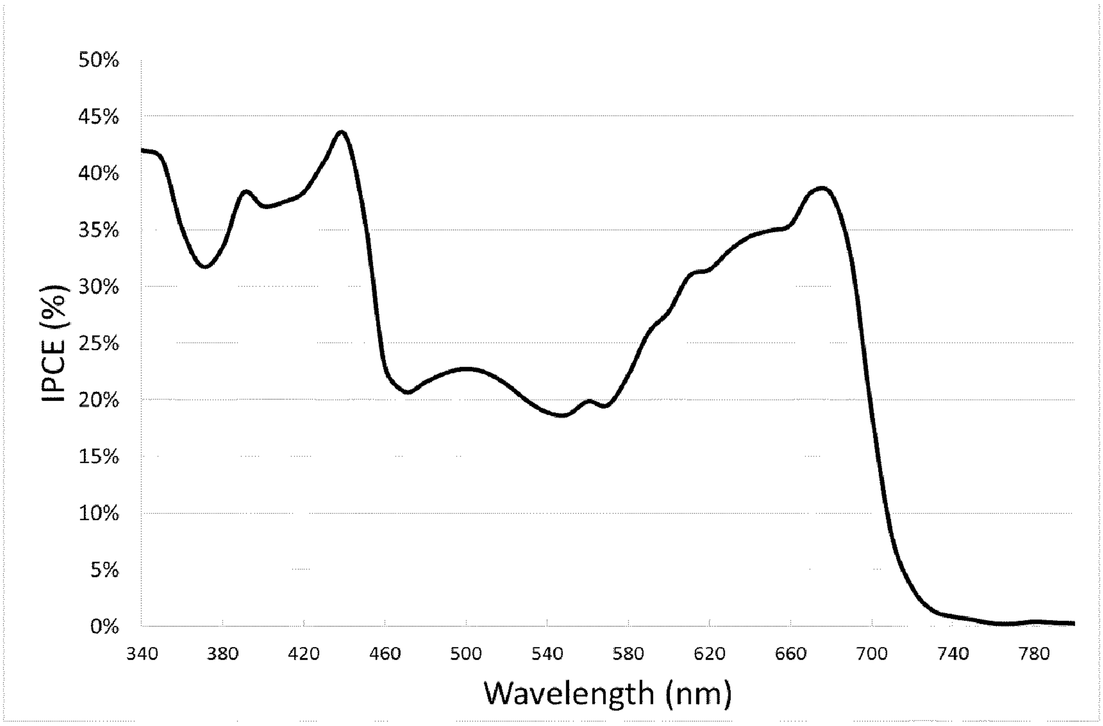
50%
45%
40%
35%
30%
25%
20%
15%
10%
5%
0%
IPCE (%)
340
380
420
460
500
540
580
620
660
700
740
780
Wavelength (nm)

**Figure 6**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 1311001 A


### Non-patent literature cited in the description


- **YELLA, A. et al.** *Science,* 2011, vol. 334, 629-634
- **MATHEW, S. et al.** *Nat. Chem.,* 2014, vol. 6, 242-247
- **IKEUCHI, T. et al.** *Chem. Commun.,* 2014, vol. 50, 1941-1943
- **ANDRIANOV, D. S. et al.** *Chem. Commun.,* 2014, vol. 50, 7953-7955
- **NAZEERUDDIN M. K.** *Journal of the American Chemical Society,* 1993, vol. 115, 6382-6390
- **CHEPRAKOV, A.V. ; M.A. FILATOV.** The dihydroisoindole approach to linearly annelated π-extended porphyrins. *Journal of Porphyrins and Phthalocyanines,* 2009, vol. 13 (03), 291-303
- **G. BOSCHLOO ; E. A. GIBSON ; A. HAGFELDT.** *J. Phys. Chem. Lett.,* 2011, vol. 2, 3016-3020